# EUROPÄISCHE PATENTSCHRIFT

(11) **EP 3 300 105 B1**
(45) Veröffentlichungstag und Bekanntmachung des Hinweises auf die Patenterteilung: **13.07.2022**
(21) Anmeldenummer: 16190518.7
(22) Anmeldetag: 26.09.2016
(51) Int. Cl.: H01L 23/488, H01L 25/07, H01L 21/48, H01L 23/544, B29C 45/14, H01L 23/00, H01L 23/31, H01L 23/373, H01L 23/538, H01L 23/18, H01L 25/18

(54) **LEISTUNGSHALBLEITERMODUL UND VERFAHREN ZUR HERSTELLUNG EINES LEISTUNGSHALBLEITERMODULS**
SEMICONDUCTOR POWER MODULE AND METHOD FOR MANUFACTURING THE SAME
MODULE SEMI-CONDUCTEUR DE PUISSANCE ET PROCÉDÉ DE FABRICATION D'UN MODULE SEMI-CONDUCTEUR DE PUISSANCE

(43) Veröffentlichungstag der Anmeldung: 28.03.2018
(73) Patentinhaber: Infineon Technologies AG, 85579 Neubiberg (DE)
(72) Erfinder: FUERGUT, Edward, 86453 Dasing (DE); GRUBER, Martin, 92421 Schwandorf (DE); LEDUTKE, Michael, 93342 Saal (DE); HOHLFELD, Olaf, 59581 Warstein (DE)
(74) Vertreter: Westphal, Mussgnug & Partner, Patentanwälte mbB

(56) Entgegenhaltungen:
- WO-A1-2012/100274
- DE-A1-102006 049 257
- DE-A1-102015 101 843
- JP-A- S5 263 672
- JP-A- 2011 009 408
- KR-A- 20100 051 291
- LARS BOETTCHER ET AL: "Development of embedded power electronics modules", ELECTRONIC SYSTEM-INTEGRATION TECHNOLOGY CONFERENCE (ESTC), 2012 4TH, IEEE, 17. September 2012 (2012-09-17), Seiten 1-6, XP032428114, DOI: 10.1109/ESTC.2012.6542167 ISBN: 978-1-4673-4645-0

## Beschreibung

### TECHNISCHES GEBIET

Die vorliegende Offenbarung betrifft ein Leistungshalbleitermodul und ein Verfahren zur Herstellung eines Leistungshalbleitermoduls.

### HINTERGRUND

Leistungshalbleitermodule, die an hohen elektrischen Spannungen und/oder mit hohen elektrischen Strömen betrieben werden, unterliegen hohen Anforderungen. Beispielsweise können beim Betrieb des Leistungshalbleitermoduls hohe Temperaturen im Modulinneren auftreten, die zu einer Überhitzung von in dem Leistungshalbleitermodul enthaltenen Bauelementen führen können. Außerdem können temperaturwechselbedingte Schäden wie z.B. das Ablösen von Bonddrähten, die durch Drahtbonden unmittelbar an eine Metallisierung gebondet sind, auftreten. Wird das Leistungshalbleitermodul an hohen elektrischen Spannungen betrieben, bestehen außerdem hohe Anforderungen an die Spannungs- und Isolationsfestigkeit des Modulaufbaus.

Aus DE 10 2015 101843 A1 ist ein Halbleitermodul bekannt, zu dessen Herstellung ein Chip auf einem Metallverbundsubstrat befestigt und mittels eines Prepreg-Harzes mit einer Kupfermetallschicht verbunden wird, so dass sich der Chip zwischen dem Metallverbundsubstrat und der Kupfermetallschicht befindet. Nachfolgend werden in die Kupfermetallschicht Öffnungen geätzt, unter denen das dort freiliegende Harz entfernt wird, so dass Mikrodurchgangsöffhungen entstehen, die sich zu einer Fläche des Chips erstrecken. In den Mikrodurchgangsöffhungen werden Mikrodurchgangslochverbindungen erzeugt, die sich von Anschlüssen des Chips zu der Kupfermetallschicht erstrecken.

In KR 2010 0051291 A wird ein Verfahren beschrieben, bei dem eine Metallfolie, die Durchgangsöffnungen aufweist und mittels eines Schaumharzes auf einem Träger befestigt ist, mittels einer Harzschicht so an einem elektronischen Element befestigt, dass sich das Schaumharz und der Träger auf der dem elektronischen Element abgewandten Seite der Metallfolie befinden. Danach werden das Schaumharz und der Träger entfernt, und die verbleibende, mit den Durchgangsöffnungen versehene Metallfolie wird als Maske verwendet, um die Harzschicht zu strukturieren und dabei Durchgangslöcher zu erzeugen, in denen Elektroden des elektronischen Elements freiliegen. Die Durchgangslöcher werden mit elektrisch leitendem Material gefüllt, um Vias zu erzeugen, die die Metallfolie mit den Elektroden verbinden.

Aus JP S52 63672 A ist eine Anordnung bekannt, bei der auf einem Halbleiterelement eine Doppelschicht aus einem Harzfilm und einem hitzeresistenten Harzsubstrat angeordnet ist. Die Doppelschicht weist Durchgangslöcher auf, unterhalb denen sich Elektrodenpads des Halbleiterelements befinden. Auf der mit den Durchgangslöchern versehenen Doppelschicht ist eine Metallschicht, die sich in die Durchgangslöcher erstreckt und die Elektrodenpads kontaktiert, konform aufgebracht. Im Bereich der Durchgangslöcher wird werden auf die Metallschicht Lotbälle positioniert und nachfolgend aufgeschmolzen, so dass das Lot den oberhalb der Metallschicht befindlichen Bereich der Durchgangslöcher fließt.

Es besteht ein allgemeiner Bedarf an einem Verfahren zur Herstellung eines Leistungshalbleitermoduls, bei dem temperaturwechselbedingte Schäden vermieden werden und mit dem sich Leistungshalbleitermodule fertigen lassen, die eine hohe Spannungs- und Isolationsfestigkeit aufweisen.

### ÜBERBLICK

Ein Aspekt betrifft ein Verfahren, bei dem in einem Verbund, der einen ersten Halbleiterchip, eine Metallplatte und eine den ersten Halbleiterchip und die Metallplatte stoffschlüssig verbindende dielektrische Verbindungsmasse aufweist, eine erste Öffnung erzeugt wird. In einem in der Verbindungsmasse befindlichen ersten Abschnitt der ersten Öffnung liegt eine erste Lastelektrode des ersten Halbleiterchips frei. Es wird eine erste elektrisch leitende Verbindung erzeugt, die die in dem ersten Abschnitt der ersten Öffnung frei liegende erste Lastelektrode kontaktiert und elektrisch leitend mit der Metallplatte verbindet. Bevor die Metallplatte durch die Verbindungsmasse stoffschlüssig mit dem ersten Halbleiterchip verbunden wird, wird eine erste Substrateinheit erzeugt, bei der der erste Halbleiterchip stoffschlüssig mit einem ersten Substrat verbunden ist. Dabei weist das erste Substrat einen dielektrischen Isolationsträger auf, der als flaches Plättchen ausgebildet ist und der eine erste Hauptfläche und eine dieser entgegengesetzte zweite Hauptfläche aufweist, wobei auf die erste Hauptfläche eine erste Substratmetallisierung aufgebracht ist.

Ein weiterer Aspekt betrifft ein Leistungshalbleitermodul, das einen Verbund mit einem ersten Halbleiterchip, einer Metallplatte sowie einer den ersten Halbleiterchip und die Metallplatte stoffschlüssig miteinander verbindende dielektrische Verbindungsmasse aufweist. Eine elektrisch leitende Verbindung, die die erste Lastelektrode kontaktiert und elektrisch leitend mit der Metallplatte verbindet, erstreckt sich durch die Verbindungsmasse. Der erste Halbleiterchip ist Bestandteil einer ersten Substrateinheit, die ein erstes Substrat und den mit dem ersten Substrat stoffschlüssig verbundenen ersten Halbleiterchip aufweist. Das erste Substrat weist einen dielektrischen Isolationsträger auf, der als flaches Plättchen ausgebildet ist und der eine erste Hauptfläche und eine dieser entgegengesetzte zweite Hauptfläche aufweist. Auf die erste Hauptfläche ist eine erste Substratmetallisierung aufgebracht.

Die Erfindung wird nachfolgend anhand von Beispielen und Bezugnahme auf die Figuren näher erläutert. Dabei bezeichnen gleiche Bezugszeichen gleiche Elemente. Die Darstellung in den Figuren ist nicht maßstäblich. Es zeigen:

### KURZBESCHREIBUNG DER ZEICHUNGEN

Die Figuren 1 bis 12 veranschaulichen verschiedene Schritte eines Verfahrens zur Herstellung eines Leistungshalbleitermoduls, bei dem in einem Verbund, bei dem ein Halbleiterchip und eine Metallplatte mittels einer dielektrischen Verbindungsmasse stoffschlüssig miteinander verbunden sind, eine erste Lastelektrode des Halbleiterchips frei gelegt und mittels einer Verbindungsschicht elektrisch leitend mit der Metallplatte verbunden wird.

Figur 13 veranschaulicht ein Verfahren zur Herstellung eines Leistungshalbleitermoduls, bei dem der Verbund an der Verbindungsschicht planarisiert wird und dadurch mehrere Abschnitte der Verbindungsschicht vereinzelt werden.

Die Figuren 14 bis 17 veranschaulichen ein Verfahren zur Herstellung eines Leistungshalbleitermoduls, bei dem der Verbund unter Verwendung einer vorgefertigten Metallplatte, die eine oder mehr Durchgangsöffnungen aufweist, erzeugt wird.

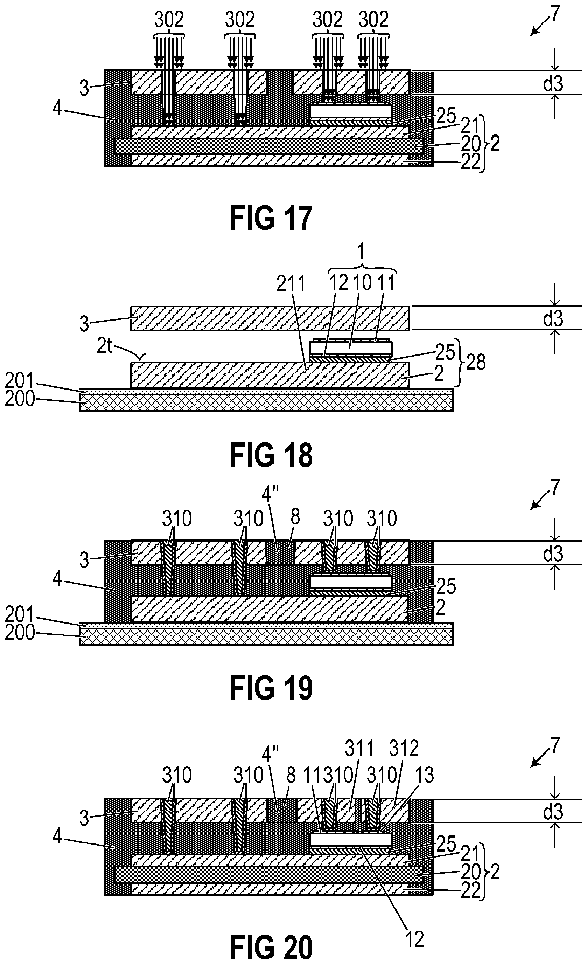

Die nicht erfindungsgemäßen Figuren 18 bis 19 veranschaulichen ein Verfahren zur Herstellung eines Leistungshalbleitermoduls, bei dem der Verbund einen Leadframe aufweist, auf dem ein Leistungshalbleiterchip angeordnet ist.

Figur 20 veranschaulicht ein Verfahren zur Herstellung eines Leistungshalbleitermoduls, bei dem die Verbindungsschicht sowohl eine Lastelektrode als auch eine Steuerelektrode eines Halbleiterchips des Leistungshalbleitermoduls elektrisch kontaktiert.

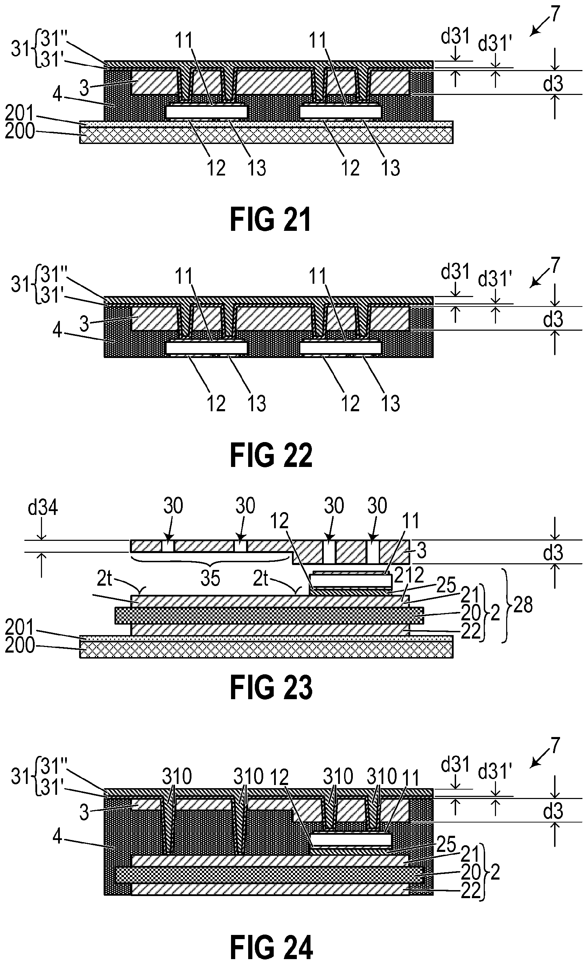

Die nicht erfindungsgemäßen Figuren 21 und 22 veranschaulichen ein Verfahren zur Herstellung eines Leistungshalbleitermoduls, bei dem, nach dem Erzeugen der Verbindungsschicht, eine Lastelektrode und eine Steuerelektrode eines Halbleiterchips des Leistungshalbleitermoduls frei liegen.

Die Figuren 23 und 24 veranschaulichen ein Verfahren zur Herstellung eines Leistungshalbleitermoduls, bei dem die Metallplatte unterschiedliche Dicken aufweist.

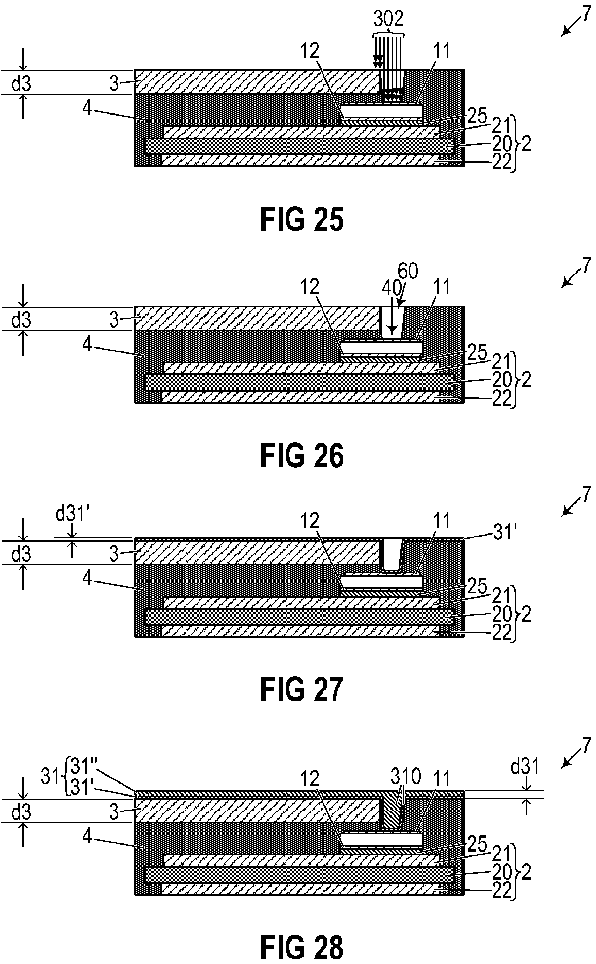

Die Figuren 25 bis 28 veranschaulichen ein Verfahren zur Herstellung eines Leistungshalbleitermoduls, bei dem ein Kontaktstöpsel seitlich neben der Metallplatte erzeugt wird.

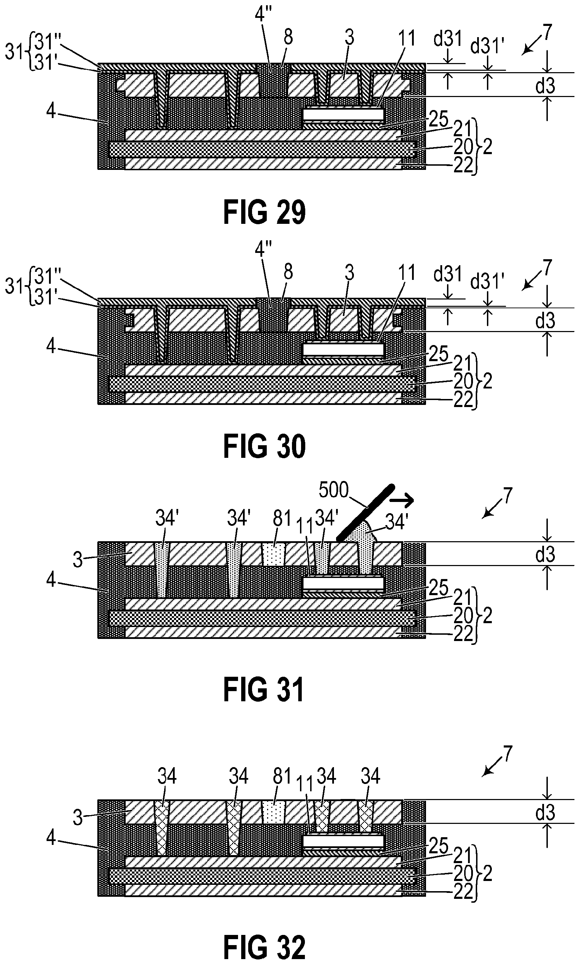

Figur 29 veranschaulicht ein Leistungshalbleitermodul, bei dem die Metallplatte eine als Vorsprung ausgebildete Verankerungsstruktur aufweist, die in die Verbindungsmasse eingreift.

Figur 30 veranschaulicht ein Leistungshalbleitermodul, bei dem die Metallplatte eine als Vertiefung ausgebildete Verankerungsstruktur aufweist, in die die Verbindungsmasse eingreift.

Die Figuren 31 und 32 veranschaulichen ein erstes Beispiel, wie zur Herstellung der elektrisch leitenden Verbindung zwischen der Metallplatte und einer Elektrode eines Halbleiterchips oder einer Elektrode einer Substratbaugruppe eine verfestigbare Masse verwendet werden kann.

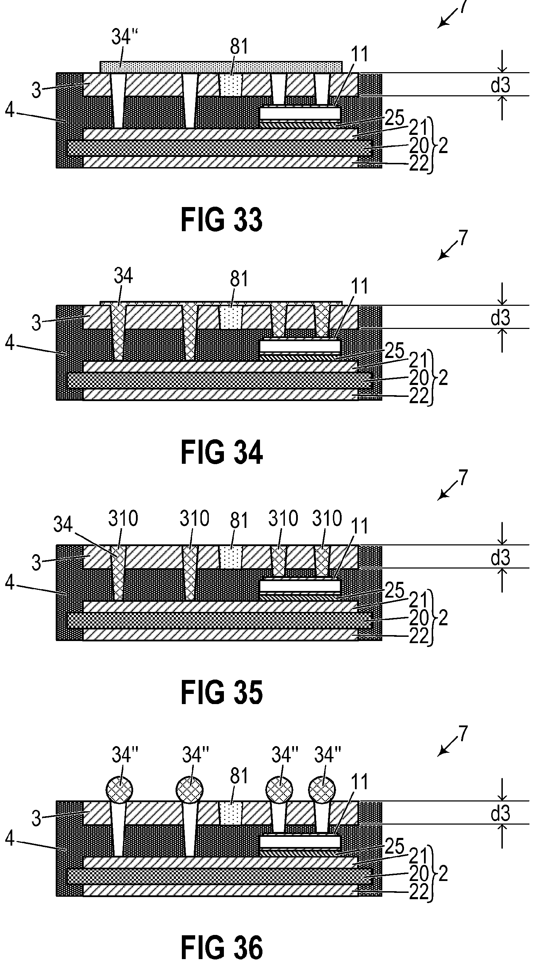

Die Figuren 33 bis 35 veranschaulichen ein zweites Beispiel, wie zur Herstellung der elektrisch leitenden Verbindung zwischen der Metallplatte und einer Elektrode eines Halbleiterchips oder einer Elektrode einer Substratbaugruppe eine verfestigbare Masse verwendet werden kann.

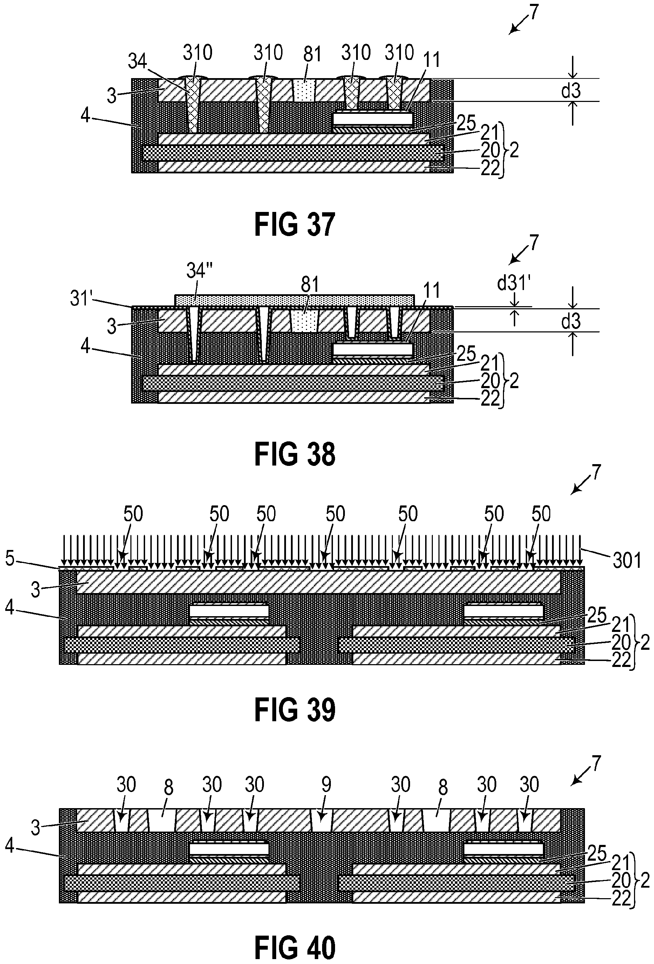

Die Figuren 36 und 37 veranschaulichen ein drittes Beispiel, wie zur Herstellung der elektrisch leitenden Verbindung zwischen der Metallplatte und einer Elektrode eines Halbleiterchips oder einer Elektrode einer Substratbaugruppe eine verfestigbare Masse verwendet werden kann.

Figur 38 veranschaulicht ein viertes Beispiel, wie zur Herstellung der elektrisch leitenden Verbindung zwischen der Metallplatte und einer Elektrode eines Halbleiterchips oder einer Elektrode einer Substratbaugruppe eine verfestigbare Masse verwendet werden kann.

Die Figuren 39 bis 43 veranschaulichen verschiedene Schritte eines Verfahrens zur Herstellung mehrerer Leistungshalbleitermodule unter Verwendung einer gemeinsamen Metallplatte.

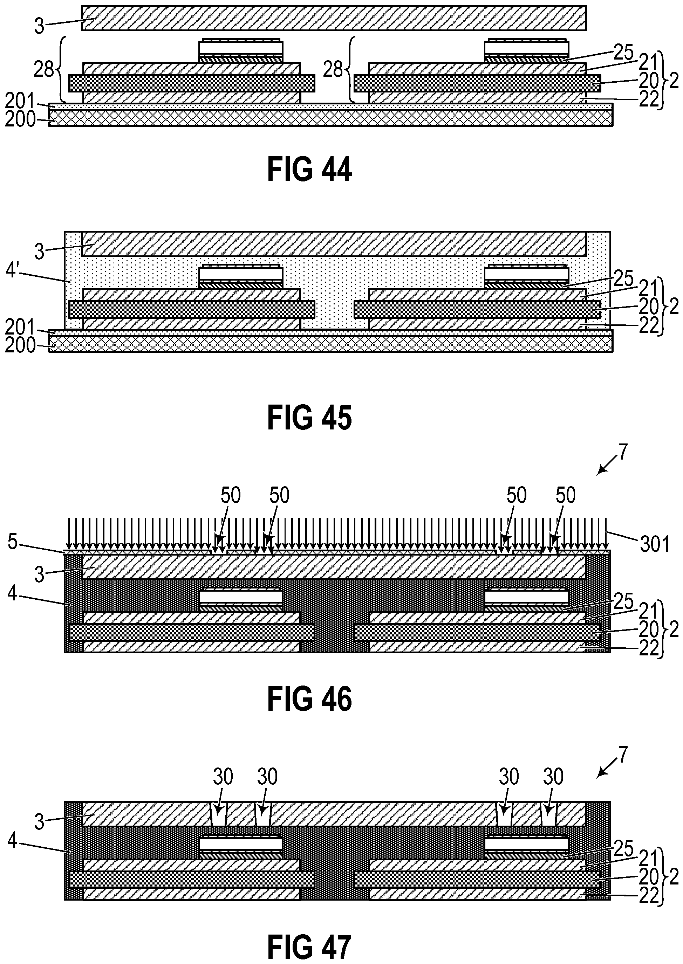

Die Figuren 44 bis 48 veranschaulichen verschiedene Schritte eines Verfahrens zur Herstellung eines Leistungshalbleitermoduls, das mehrere Substratbaugruppen aufweist, die mittels einer Metallplatte elektrisch miteinander verbunden sind.

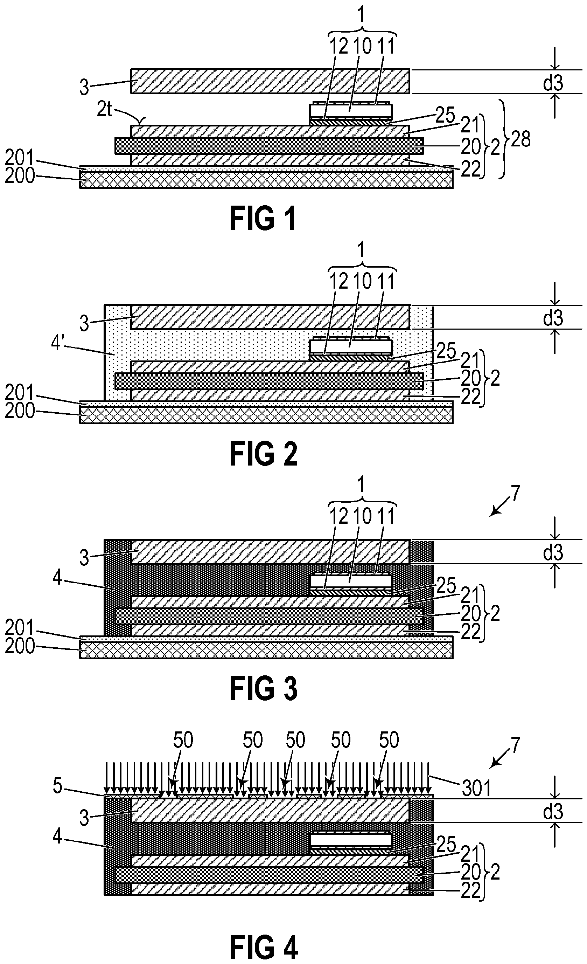

Figur 1 zeigt einen Querschnitt durch einen Abschnitt einer Anordnung mit einem Halbleiterchip 1 und einer mit dem Halbleiterchip 1 stoffschlüssig zu verbindenden Metallplatte 3. Der Halbleiterchip 1 kann dazu, beispielsweise mittels einer Klebeschicht 201, vorübergehend auf einem Hilfsträger 200 befestigt werden. Bei dem gezeigten Beispiel erfolgt die Befestigung des Halbleiterchips 1 auf dem Hilfsträger 200 mittelbar über ein Substrat 2 und eine Verbindungsschicht 25, was später noch ausführlicher erläutert wird. Die Metallplatte 3 oder ein oder mehr Segmente der Metallplatte 3 dienen bei dem fertigen Leistungshalbleitermodul zur Umverdrahtung. Die Metallplatte 3 weist eine maximale Dicke d3 auf. Diese kann beispielsweise im Bereich von 100 µm bis 2000 µm liegen, oder im Bereich von 100 µm bis 500 µm. Metallplatten 3 mit einer maximale Dicken d3 von weniger als 100 µm oder von mehr als 2000 µm können jedoch ebenfalls verwendet werden. Als Material für die Metallplatte 3 eignen sich elektrisch gut leitende Metalle (einschließlich Legierungen). Zum Beispiel kann die Metallplatte 3 aus einem der folgenden Metalle bestehen, oder wenigstens 50 Gewichtsprozent aus genau einem oder mehr als einem der folgenden Metalle aufweisen: Kupfer (Cu); Aluminium (Al); Molybdän (Mo); Silber (Ag); Gold (Au). Alternativ kann die Metallplatte 3 einen Mehrschicht-Aufbau mit wenigstens zwei metallischen Schichten unterschiedlicher Zusammensetzung aufweisen. Beispielsweise kann die Metallplatte 3 zwei Kupferschichten aufweisen, zwischen denen eine Molybdänschicht angeordnet ist.

Bei dem gezeigten Beispiel wurde der vorgefertigte Halbleiterchip 1 auf einem vorgefertigten Substrat 2 angeordnet und mittels einer Verbindungsschicht 25 stoffschlüssig mit dem vorgefertigten Substrat 2 verbunden. Beispielsweise kann der Halbleiterchip 1 mittels der Verbindungsschicht 25 mit einer metallischen Oberfläche 2t des Substrats 2 elektrisch leitend oder elektrisch isolierend verbunden sein. Eine Einheit, bei der ein Halbleiterchip 1 auf einem Substrat 2 angeordnet und mittels einer Verbindungsschicht 25 stoffschlüssig mit dem Substrat 2 verbunden ist, wird nachfolgend auch als Substratbaugruppe 28 bezeichnet. Bei der Verbindungsschicht 25 kann es sich beispielsweise um eine Lotschicht handeln, um eine Schicht mit einem gesinterten Metallpulver, oder um eine elektrisch leitende oder elektrisch isolierende Klebeschicht. Der Hilfsträger 200 und die Klebeschicht 201 befinden sich an der dem Halbleiterchip 1 abgewandten Seite des Substrats 2, und die dem Halbleiterchip 1 abgewandte Seite des Substrats 2 haftet unmittelbar an der Klebeschicht 201. Bei dem gezeigten Beispiel ist der Halbleiterchip 1 also durch die Klebeschicht 201 über das Substrat 2 und die Verbindungsschicht 25 mittelbar mit dem Hilfsträger 200 verklebt. Alternativ dazu könnte der Halbleiterchip 1 an seiner der Metallplatte 3 abgewandten Seite auch direkt an der Klebeschicht 201 anhaften. In diesem Fall könnten das Substrat 2 und die Verbindungsschicht 25 weggelassen werden. Grundsätzlich könnten aber auch der Hilfsträger 200 und die Klebeschicht 201 weggelassen werden. In jedem Fall werden der Halbleiterchip 1 und die Metallplatte 3, abhängig von der jeweiligen Applikation, in eine bestimmte relative Lage zueinander gebracht, um einen Verbund 7 zu erzeugen, bei dem der Halbleiterchip 1 und die Metallplatte 3, wie im Ergebnis in Figur 3 gezeigt, mittels einer Verbindungsmasse 4 fest und stoffschlüssig miteinander zu verbinden. Daher erstreckt sich die Verbindungsmasse 4 bei dem fertigen Verbund 7 durchgehend zwischen dem Halbleiterchip 1 und der Metallplatte 3.

Auf entsprechende Weise können auch mehr als ein Halbleiterchip 1 auf dem Substrat 2 angeordnet und jeweils mittels einer Verbindungsschicht 25 stoffschlüssig mit dem Substrat 2 verbunden sein. Hierdurch lassen sich beliebige Schaltungen wie zum Beispiel Halbbrücken, H-Brücken, 3-Phasenumrichter, Logik-Halbleiterchips, Sensorchips in das herzustellende Leistungshalbleitermodul integrieren.

Zur Herstellung des Verbunds 7 kann, wie in Figur 2 dargestellt, ein fließfähiges Vorprodukt 4' der dielektrischen Verbindungsmasse 4 zwischen den Halbleiterchip 1 und die Metallplatte 3 eingebracht und nachfolgend zu einem die Verbindungsmasse 4 bildenden festen Körper ausgehärtet, der sich durchgehend zwischen dem Halbleiterchip 1 und der Metallplatte 3 erstreckt und den Halbleiterchip 1 und die Metallplatte 3 stoffschlüssig miteinander verbindet.

Die Verbindungsmasse 4 kann beispielsweise einen Kunststoff enthalten oder aus einem Kunststoff bestehen. Geeignete Kunststoffe sind zum Beispiel Duroplaste, aber auch Thermoplaste. Ebenso kann die Verbindungsmasse 4 eine ausgehärte Harz-Härter-Mischung enthalten oder aus einer ausgehärten Harz-Härter-Mischung bestehen. Das Vorprodukt 4' der Verbindungsmasse 4 kann fließfähig sein, so dass es in fließfähigem Zustand (zum Beispiel durch Spritzpressen (engl.: "transfer molding") oder Formpressen (engl.: "compression molding")) zwischen den Halbleiterchip 1 und die Metallplatte 3 gegossen oder gespritzt werden kann, wenn sich diese in der vorgegebenen relativen Lage zueinander befinden. Alternativ ist es auch möglich, das Vorprodukt 4' zunächst auf den Halbleiterchip 1 zu gießen oder zu spritzen (zum Beispiel mittels eines Gieß- oder Spritzgießverfahrens oder durch Dispensen) und die Metallplatte 3 auf das Vorprodukt 4' aufzusetzen, solange es noch nicht ausgehärtet ist. Umgekehrt ist es auch möglich, das Vorprodukt 4' zunächst auf die Metallplatte 3 zu gießen oder zu spritzen und den Halbleiterchip 1 auf das Vorprodukt 4' aufzusetzen, solange es noch nicht ausgehärtet ist. Im Ergebnis erstreckt sich bei all diesen Alternativen das noch nicht ausgehärtete Vorprodukt 4' durchgehend zwischen dem Halbleiterchip 1 und der Metallplatte 3. Danach kann das Vorprodukt 4', während sich der Halbleiterchip 1 und die Metallplatte 3 in der vorgegebenen relativen Lage befinden, zu der festen Verbindungsmasse 4 ausgehärtet werden.

Zusätzlich zu einem Kunststoff oder einem Harz wie erwähnt kann die Verbindungsmasse 4 mit einem Füllstoff hoch gefüllt sein. Zur Herstellung einer solchen hoch gefüllten Verbindungsmasse 4 können das Vorprodukt 4' und damit auch die Verbindungsmasse 4 einen Füllstoff aus dielektrischen Körnern enthalten, die dem Vorprodukt 4' beigemischt werden und damit auch Bestandteil der ausgehärteten Verbindungsmasse 4 sind. Als Füllstoff eignen sich beispielsweise Materialien mit einem geringen linearen thermischen Ausdehnungskoeffizienten. Durch die Verwendung derartiger Füllstoffe lässt sich preiswert eine Verbindungsmasse 4 mit einer hohen mechanischen Festigkeit und einem geringen linearen thermischen Ausdehnungskoeffizienten erzielen. Ferner lässt sich durch die Verwendung eines solchen Füllstoffs die Wärmeleitfähigkeit der Verbindungsmasse 4 im Vergleich zu einer ungefüllten Verbindungsmasse 4, die nur aus einem Kunststoff oder einem Harz besteht, erhöhen. Außerdem kann durch einen Füllstoff, der weniger Feuchtigkeit pro Volumen absorbiert als der Kunststoff oder das Harz, die Feuchtigkeitsaufnahme der Verbindungsmasse 4 gegenüber einer ungefüllten, nur aus Kunststoff oder Harz bestehenden Verbindungsmasse 4 verringern. In diesem Sinn wird eine linearer thermischer Ausdehnungskoeffizient als gering angesehen, wenn er, bezogen auf eine Temperatur von 18°C, keiner ist als 20 ppm/K. Beispiele für geeignete Füllstoffe stellen Siliziumdioxid, Aluminiumoxid, Bornitrid, Siliziumnitrid, Aluminiumnitrid, Diamant oder Glas dar. Weiterhin wird ein gefüllter Kunststoff oder ein gefülltes Harz dann als "hoch gefüllt" angesehen, wenn die Gesamtmenge des in den Kunststoff oder in das Harz eingebetteten Füllstoffs mindestens 60 Volumenprozent vom Gesamtvolumen aus dem Kunststoff bzw. dem Harz sowie dem Füllstoff aufweist.

Um eine korrekte Justierung der Metallplatte 3 relativ zu dem Halbleiterchip 1 zu erreichen, können beispielsweise Justiervorsprünge (z.B. Pins) verwendet werden, die in korrespondierende Justieröffnungen eingreifen. Die Justiervorsprünge können beispielsweise an der Metallplatte 3 ausgebildet sein und die Justieröffnungen an dem Hilfsträger 200, auf den der Halbleiterchip 1 aufgeklebt ist. Umgekehrt können die Justieröffnungen auch an der Metallplatte 3 ausgebildet sein und die Justiervorsprünge an dem Hilfsträger 200. Sofern das Einbringen des Vorprodukts 4' zwischen den Halbleiterchip 1 und die Metallplatte 3 mittels eines Spritzgießverfahrens erfolgt, bei dem der Halbleiterchip 1 und die Metallplatte 3 in eine Spritzgießform eingesetzt werden, können Justieröffnungen und/oder -vorsprünge auch an der Spritzgießform angebracht sein. Ebenso besteht die Möglichkeit, die Lage der Metallplatte 3 optisch zu erkennen und bei Bedarf (z.B. durch eine automatische Positioniervorrichtung) so zu korrigieren, dass sie sich in der gewünschten relativen Lage zu dem Halbleiterchip 1 befindet.

Der Halbleiterchip 1 weist einen Halbleiterkörper 10 aus einem Halbleitergrundmaterial auf, in dem zur Realisierung eines in den Halbleiterkörper 10 integrierten Leistungshalbleiterbauelements insbesondere p-leitende und n-leitende Halbleiterzonen enthalten sein können. Außerdem kann der Halbleiterchip 1 noch beliebig viele elektrisch leitende Schichten aufweisen wie zum Beispiel Metallisierungen, Silizidschichten oder Schichten aus dotiertem polykristallinem Halbleitermaterial (z. B. polykristallines Silizium), aber auch beliebig viele dielektrische Schichten wie beispielsweise Nitridschichten (z. B. Siliziumnitrid) oder Oxidschichten (z. B. Siliziumoxid), oder Passivierungsschichten wie z. B. Imidschichten. Bei dem Halbleitergrundmaterial kann es sich um jedes bekannte zur Herstellung von Halbleiterbauelementen übliche Halbleitergrundmaterial handeln, beispielsweise um beliebige Elementhalbleiter (z. B. Silizium, Germanium), um beliebige Verbindungshalbleiter (z. B. II-VI-Halbleiter wie Zinkselenid oder Cadmiuimsulfid, III-V-Halbleiter wie Galliumphosphid, Galliumarsenid, Indiumphosphid, Indiumantimonid, oder IV-IV-Halbleiter wie Silziumkarbid oder Siliziumgermanium). Das Halbleitergrundmaterial kann auch eine Galliumnitridschicht aufweisen, die auf einem Siliziumsubstrat oder auf einem Silziumkarbidsubstrat angeordnet ist.

Optional kann es sich bei dem Halbleiterchip 1 um einen "Nacktchip" (engl.: "bare chip") handeln, bei dem der Halbleiterkörper 10 frei liegt. Bei einem derartigen Halbleiterchip 1 kann sich die Verbindungsmasse 4 bis zu dem Halbleiterkörper 10 erstrecken und unmittelbar an diesen angrenzen.

Auf den Halbleiterkörper 10 sind eine erste Lastelektrode 11 und eine zweite Lastelektrode 12 aufgebracht. Unter einer "ersten Lastelektrode 11" und einer zweiten Lastelektrode 12" sind Elektroden zu verstehen, zwischen denen eine Laststrecke des in den Halbleiterkörper 10 integrierten Leistungshalbleiterbauelements ausgebildet ist und die beim Betrieb des Halbleiterchips 1 von einem hohen Laststrom durchflossen werden kann. Allgemein ist eine "Lastelektrode" eine von zwei Chip-Elektroden 11, 12, zwischen denen eine Laststrecke des in den Halbleiterkörper 10 integrierten Leistungshalbleiterbauelements ausgebildet ist. Die Laststrecke kann beispielsweise so ausgelegt sein, dass sie dauerhaft von einem Strom von wenigstens 5 A oder gar wenigstens 50 A durchflossen werden kann, ohne dass das Leistungshalbleiterbauelement zerstört wird. Sofern die Laststrecke von einem elektrischen Strom durchflossen wird, fließt dieser Strom durch den Halbleiterkörper 10, d.h. durch ein Halbleitermaterial des Halbleiterkörpers 10. Optional kann der Halbleiterchip 1 zwischen der ersten Lastelektrode 11 und der zweiten Lastelektrode 12 ein Spannungssperrvermögen von wenigstens 600 V aufweisen. Bei sämtlichen erläuterten Beispielen wird immer beispielhaft die erste Lastelektrode 11 mittels einer elektrisch leitenden Verbindungsschicht 31 elektrisch leitend mit der Metallplatte 3 verbunden.

Bei dem gezeigten Beispiel befinden sich die erste Lastelektrode 11 und die zweite Lastelektrode 12 auf entgegengesetzten Oberflächen des Halbleiterkörpers 10, so dass der Halbleiterkörper 10 zwischen der ersten Lastelektrode 11 und der zweiten Lastelektrode 12 angeordnet sind. Prinzipiell kann sich die zweite Lastelektrode 12 im Verhältnis zur ersten Lastelektrode 11 an einer beliebigen Stelle befinden. Beispielsweise könnten die erste Lastelektrode 11 und die zweite Lastelektrode 12 auch auf derselben Oberfläche des Halbleiterkörpers 10 angeordnet sein. Wie anhand des vorliegenden Beispiels ebenfalls gezeigt ist, kann die zweite Lastelektrode 12 durch die an sie und die metallische Oberfläche 2t des Substrats 2 angrenzende Verbindungsschicht 25 stoffschlüssig und elektrisch leitend mit der metallischen Oberfläche 2t verbunden sein.

Optional könnte der Halbleiterchip 1 noch eine Steuerelektrode 13 aufweisen. Beispiele mit einem derartigen Halbleiterchip 1 sind in den Figuren 20 bis 22 gezeigt. Über eine solche Steuerelektrode 13 kann die zwischen der ersten Lastelektrode 11 und der zweiten Lastelektrode 12 ausgebildete Laststrecke angesteuert werden. Beispielsweise kann die Laststrecke abhängig von einem Steuersignal, das dem Leistungshalbleiterbauelement über die Steuerelektrode 13 zugeführt wird, in einen elektrisch leitenden oder elektrisch sperrenden Zustand versetzt werden. Die Steuerelektrode 13 kann beispielsweise als Gateelektrode oder als Basiselektrode ausgebildet sein.

Bei der ersten Lastelektrode 11, der zweiten Lastelektrode 12, und, soweit vorhanden, der Steuerelektrode 13 kann es sich beispielsweise um dünne Metallisierungsschichten handeln. Derartige Metallisierungsschichten können zum Beispiel bereits während der Herstellung des Halbleiterchips 1 auf den Halbleiterkörper 10 aufgebracht werden, wenn sich der Halbleiterchip 1 noch im Waferverbund mit weiteren, Halbleiterchips 1 befindet, also noch vor dem Vereinzeln des Wafers zu voneinander unabhängigen Halbleiterchips 1 und damit auch, bevor der Halbleiterchip 1 durch die Verbindungsmasse 4 stoffschlüssig mit der Metallplatte 3 verbunden wird. Demgemäß können die erste Lastelektrode 11, die zweite Lastelektrode 12 und die Steuerelektrode 13 auch als "Chipelektroden" bezeichnet werden. Bei der ersten Lastelektrode 11, der zweiten Lastelektrode 12 und (sofern vorhanden) der Steuerelektrode 13 kann es sich jeweils um Metallschichten handeln. Die Materialien der ersten Lastelektrode 11, der zweiten Lastelektrode 12 und der Steuerelektrode 13 (sofern vorhanden) können unabhängig voneinander gewählt werden. Die Schichtdicken der ersten Lastelektrode 11 und der zweiten Lastelektrode 12 sind prinzipiell beliebig und sie können unabhängig voneinander gewählt werden. Beispielsweise kann die Schichtdicke der ersten Lastelektrode 11 wenigstens 2 µm, wenigstens 10 µm oder gar wenigstens 20 µm betragen. Geeignete Materialien für die erste Lastelektrode 11, die zweite Lastelektrode 12 und (sofern vorhanden) die Steuerelektrode 13 sind Metalle einschließlich Legierungen, aber auch andere elektrische Leiter. Beispielsweise können eine erste Lastelektrode 11 und eine zweite Lastelektrode 12, unabhängig voneinander, jeweils eines der folgenden Materialien aufweisen oder aus einem der folgenden Materialien bestehen: Kupfer; Aluminium; Kupfer und Aluminium. Optional kann die erste Lastelektrode 11 Kupfer aufweisen oder aus Kupfer bestehen, während die zweite Lastelektrode 12 frei von Kupfer sein kann.

Bei dem in den Halbleiterchip 1 integrierten Leistungshalbleiterbauelement kann es sich beispielsweise um eine Diode handeln, oder um einen steuerbaren Halbleiterschalter wie z.B. einen IGBT (Insulated Gate Bipolar Transistor), einen MOSFET (Metal Oxide Semiconductor Field Effect Transistor), einen Thyristor (z.B. einen GTO-Thyristor; GTO = Gate Turn-Off), einen Sperrschicht-Feldeffekttransistor (JFET = Junction Field Effect Transistor), oder um einen HEMT (High Electron Mobility Transistor). Bei Leistungshalbleiterbauelement kann es sich um ein vertikales oder um ein laterales Leistungshalbleiterbauelement handeln. Es wird darauf hingewiesen, dass der Halbleiterchip 1 nicht auf die genannten Beispiele beschränkt ist.

Bei der ersten Lastelektrode 11 und der zweiten Lastelektrode 12 kann es sich beispielsweise, je nach Art des Bauelements, um eine Source- und eine Drain-Elektrode handeln, oder um eine Drain- und eine Source-Elektrode, oder um eine Kollektor- und eine Emitter- Elektrode, oder um eine Emitter-und eine Kollektor- Elektrode, oder um eine Anoden- und eine Kathoden- Elektrode, oder um eine Kathoden- und eine Anoden-Elektrode. Sowohl die erste Lastelektrode 11 als auch die zweite Lastelektrode 12 können verschieden von einer Steuerelektrode sein, insbesondere verschieden sowohl von einer Gate-Elektrode als auch verschieden von einer Basis-Elektrode.

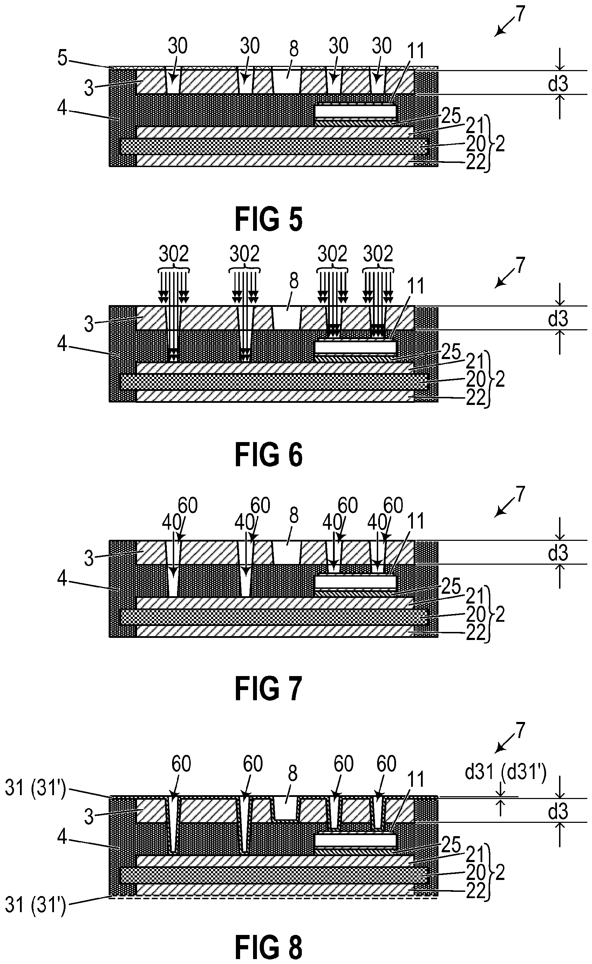

Ausgehend von einem Verbund 7, bei dem der Halbleiterchip 1 und die Metallplatte 3 mittels einer Verbindungsmasse 4 fest und stoffschlüssig miteinander verbunden sind, kann die Metallplatte 3 derart strukturiert werden, dass sie eine oder mehr Durchgangsöffnungen 30 aufweist, die später - jeweils unter Ausbildung eines Abschnitts 40 der herzustellenden Öffnung 60, zu den herzustellenden Öffnungen 60 (Figur 7) erweitert werden. Figur 5 zeigt die Anordnung nach der Herstellung der Durchgangsöffnungen 30. Das Erzeugen der Durchgangsöffnungen 30 kann beispielsweise mittels eines maskierten Ätzverfahrens erfolgen, was in Figur 4 schematisch dargestellt ist. Bei diesem maskierten Ätzverfahren wird auf einer Oberfläche der Metallplatte 3 eine strukturierte Ätzmaskenschicht 5 erzeugt, die eine oder mehr Maskenöffnungen 50 aufweist. In einer jeden Maskenöffnung 50 liegt die Metallplatte 3 frei, so dass während des Ätzvorgangs ein Ätzmittel 301 durch die Maskenöffnung 50 an die Metallplatte 3 gelangt und das Material der Metallplatte 3 im Bereich der Maskenöffnung 50 lokal entfernt, so dass in der Metallplatte 3 eine Durchgangsöffnung 30 entsteht, die einen Abschnitt der herzustellenden Öffnung 60 bildet. Die Durchgangsöffnung 30 erstreckt sich durchgehend zwischen zwei entgegengesetzten Oberflächen der Metallplatte 3. Als Ätzverfahren eignen sich beispielsweise anisotrope Ätzverfahren wie beispielsweise (reaktives Ionenätzen; "RIE"), oder auch isotrope Ätzverfahren mit einem flüssigen Ätzmittel. Außerdem wird im Bereich einer weiteren Maskenöffnung 50 (in Figur 4 ist dies die mittlere der Maskenöffnungen 50) eine Durchgangsöffnung 8 erzeugt, die die Metallplatte 3 in zwei oder mehr Segmente trennt, was im Ergebnis in Figur 6 gezeigt ist.

Unabhängig von dem eingesetzten Ätzverfahren kann die strukturierte Maskenschicht 5 auf beliebige Weise erzeugt werden, beispielsweise photolithographisch, mittels LDI (Laser Direct Imaging), etc., was an sich bekannt ist und daher nicht näher erläutert wird. In jedem Fall ist die Maskenschicht 5 so ausgebildet, dass sie gegenüber dem zum lokalen Entfernen des Materials der Metallplatte 3 verwendeten Ätzmittel ätzresistent ist, oder gegenüber dem Ätzmittel zumindest eine geringere Ätzrate aufweist als das Material der Metallplatte 3.

Bei dem gezeigten Beispiel werden die Durchgangsöffnungen 30 in einem Zustand erzeugt, in dem die Metallplatte 3 bereits durch die Verbindungsmasse 4 stoffschlüssig mit dem Halbleiterchip 1 verbunden ist. In diesem Fall wird die Maskenschicht 5 auf der dem Halbleiterchip 1 abgewandten Oberfläche der Metallplatte 3 erzeugt. Grundsätzlich besteht jedoch auch die Möglichkeit, die Durchgangsöffnungen 30 in einem Zustand zu erzeugen, in dem die Metallplatte 3 noch nicht durch die Verbindungsmasse 4 stoffschlüssig mit dem Halbleiterchip 1 verbunden ist. Auch hier kann ein maskiertes Ätzverfahren eingesetzt werden, wie es vorangehend beschrieben wurde. Dabei kann die Ätzmaskenschicht 5 auf der Oberfläche der Metallplatte 3 erzeugt werden, die bei dem später erzeugten Verbund 7 dem Halbleiterchip 1 abgewandt ist, aber auch auf der Oberfläche der Metallplatte 3, die bei dem später erzeugten Verbund 7 dem Halbleiterchip 1 zugewandt ist.

Wie weiter anhand von Figur 6 und im Ergebnis in Figur 7 gezeigt ist, kann in der Verbindungsmasse 4 für eine oder mehr herzustellende Öffnungen 60 jeweils ein Abschnitt 40 derart erzeugt werden, dass dieselbe erste Lastelektrode 11 in jedem dieser Abschnitte 40 und damit in den entsprechenden Öffnungen 60 frei liegt. Die Figuren 6 und 7 zeigen lediglich beispielhaft zwei derartige Abschnitte 40 (und damit einhergehend zwei Öffnungen 60), in denen dieselbe erste Lastelektrode 11 jeweils frei liegt. Die Anzahl solcher Abschnitte 40 (und damit die Anzahl solcher zweiter Öffnungen 60), in denen dieselbe erste Lastelektrode 11 frei liegt, ist grundsätzlich beliebig.

Wie in den Figuren 6 und 7 ebenfalls gezeigt ist, können in der Verbindungsmasse 4 optional eine oder mehr weitere Abschnitte 40 derart erzeugt werden, dass das Substrat 2 darin jeweils frei liegt. Die Figuren 6 und 7 zeigen lediglich beispielhaft zwei derartige weitere Abschnitte 40. Sofern eine oder mehr solche weiteren Abschnitte 40 erzeugt werden, ist deren Anzahl grundsätzlich beliebig. Soweit Abschnitte 40 bzw. weitere Abschnitte 40 vorgesehen sind, können sich diese jeweils durchgehend zwischen zwei entgegengesetzten Oberflächen der Verbindungsmasse 4 erstrecken, so dass der betreffende Abschnitt 40 eine Durchgangsöffnung der Verbindungsmasse 4 bildet.

Das Erzeugen von einem oder mehr Abschnitten 40 kann prinzipiell auf beliebige Weise erfolgen. Dabei können die Abschnitte 40 im Fall von zwei oder mehr Abschnitten 40 simultan oder nacheinander erzeugt werden. Gemäß dem anhand von Figur 6 gezeigten Beispiel werden die Abschnitte 40 dadurch erzeugt, dass die Verbindungsmasse 4 mittels eines Laserstrahls 302 lokal geöffnet wird. Hierbei können die in der Metallplatte 3 ausgebildeten Durchgangsöffnungen 30 als Maskenöffnungen und die Metallplatte 3 mithin als Maske für den Laserstrahl 302 verwendet werden, so dass der Laserstrahl 302 nur in den Bereichen Material der Verbindungsmasse 4 abträgt, in denen er durch die Durchgangsöffnungen 30 auf die Verbindungsmasse 4 trifft. Es wird darauf hingewiesen, dass die Darstellung gemäß Figur 6 lediglich veranschaulichen soll, das die Metallplatte 3 als Maske für den Laserstrahl 302 verwendet werden kann. Figur 6 ist jedoch nicht so zu verstehen, dass der Laserstrahl 302 so bemessen sein muss, dass er simultan zwei oder mehr Durchgangsöffnungen 30 erfasst. Beispielsweise kann der Laserstrahl 302 so bemessen sein, dass er dazu in der Lage ist, im Bereich von nur einer Durchgangsöffnung 30 einen Abschnitt 40 zu erzeugen. Der Laserstrahl 302 kann dann sukzessive von einer Durchgangsöffnung 30 zu einer anderen Durchgangsöffnung 30 bewegt werden und dabei jeweils im Bereich der betreffenden Durchgangsöffnung 30 einen korrespondierenden Abschnitt 40 zu erzeugen, so dass die Durchgangsöffnung 30 und der korrespondierende Abschnitt 40 Abschnitte einer Öffnung 60 bilden, in der die erste Lastelektrode 11 frei liegt, was im Ergebnis in Figur 7 gezeigt ist. Auf entsprechende Weise können auch eine oder mehr weitere Öffnungen 60 erzeugt werden, in denen eine elektrisch leitende Oberfläche 2t des Substrats 2, beispielsweise eine elektrisch leitende Oberfläche 2t einer Leiterbahn des Substrats 2, frei liegt, was im Ergebnis ebenfalls in Figur 7 dargestellt ist. Jeweils eine Durchgangsöffnung 30 und ein Abschnitt 40 können also zusammen eine Öffnung 60 bilden, in der die erste Lastelektrode 11 oder eine metallische Oberfläche des Substrats 2 frei liegt. Im Bereich der Durchgangsöffnung 8 wird jedoch kein oder im Wesentlichen kein Material der Verbindungsmasse 4 durch den Laserstrahl 302 abgetragen.

Um nun eine erste Lastelektrode 11 elektrisch leitend mit der Metallplatte 3 zu verbinden, wird auf dem Verbund 7, der den Halbleiterchip 1, die Metallplatte 3 sowie die Verbindungsmasse 4 enthält, eine elektrisch leitende Verbindungsschicht 31 erzeugt, die die in dem Abschnitt 40 bzw. die in der Öffnung 60 frei liegende erste Lastelektrode 11 des Halbleiterchips 1 elektrisch kontaktiert und elektrisch mit der Metallplatte 3 verbindet. Optional kann die Verbindungsschicht 31 auch eine in einem weiteren Abschnitt 40 bzw. in einer zu diesem Abschnitt 40 gehörenden Öffnung 60 frei liegende metallische Oberfläche 2t des Substrats 2 elektrisch kontaktierten und elektrisch mit der Metallplatte 3 verbinden. Bei der Verbindungsschicht 31 kann es sich zum Beispiel um eine Metallschicht oder eine Schicht aus oder mit einem anderen elektrisch gut leitenden Material handeln.

Die elektrisch leitende Verbindungsschicht 31 kann zum Beispiel dadurch erzeugt werden, dass das die elektrisch leitende Verbindungsschicht 31 bildende Material auf dem den Halbleiterchip 1, die Metallplatte 3 sowie die Verbindungsmasse 4 enthaltenden Verbund 7 mittels eines chemischen und/oder eines physikalischen Abscheideverfahrens abgeschieden wird. Geeignete Abscheideverfahren sind beispielsweise chemische Abscheideverfahren wie chemische Gasphasenabscheidung ("CVD") oder außenstromlose chemische Abscheidung, oder physikalische Abscheideverfahren wie physikalische Gasphasenabscheidung (PVD) wie Aufdampfen, Aufschleudern, Kathodenzerstäubung (Sputtern). Optional kann als Abscheideverfahren ein konformes Abscheideverfahren eingesetzt werden.

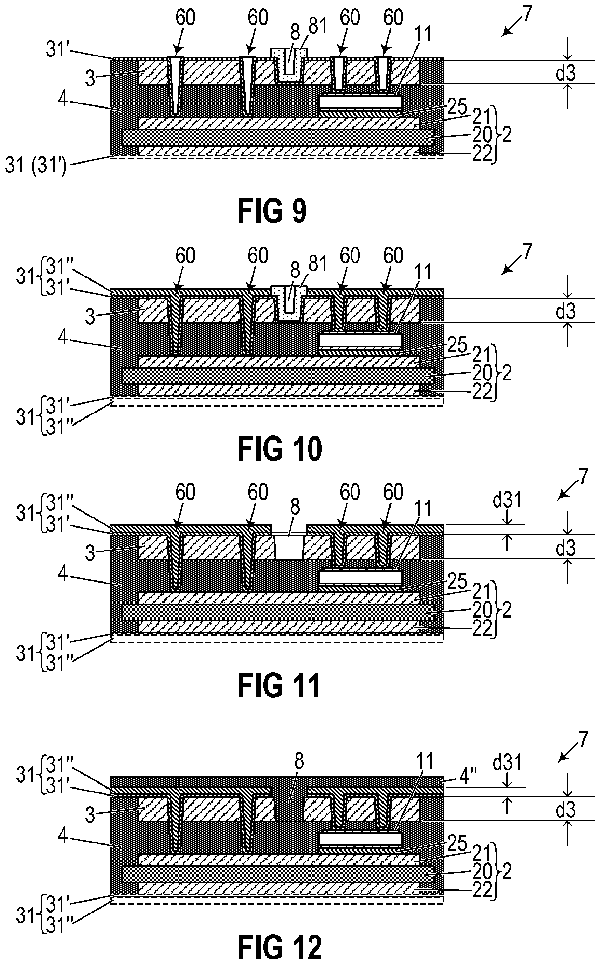

Durch das Erzeugen der Verbindungsschicht 31 sind die erforderlichen elektrischen Verbindungen zwischen der Metallplatte 3 und der ersten Lastelektrode 11 sowie optional auch zwischen der Metallplatte 3 und einer metallischen Oberfläche 2t des Substrats 2 hergestellt, so dass das Leistungshalbleitermodul bereits verwendet werden kann. Bei dem gezeigten Beispiel gemäß Figur 8 füllt die Verbindungsschicht 31 den Abschnitt 40 und damit die Öffnung 60 nicht vollständig aus. Um die Stromtragfähigkeit der durch die Verbindungsschicht 31 bewirkten elektrischen Verbindungen zwischen der Metallplatte 3 und der ersten Lastelektrode 11 und, soweit vorgesehen, zwischen der Metallplatte 3 und dem Substrat 2 zu erhöhen, können der Abschnitt 40 und optional auch die Öffnung 60 vollständig durch die Verbindungsschicht 31 verfüllt werden, was im Ergebnis in Figur 9 dargestellt ist. Im Bereich einer Öffnung 60 bildet die Verbindungsschicht 31 dann einen massiven Kontaktstöpsel 310. Demgemäß verläuft ein Abschnitt der Verbindungsschicht 31 durch die Öffnung 60, kontaktiert die in der Öffnung 60 frei liegende erste Lastelektrode 11 und verbindet diese elektrisch leitend mit der Metallplatte 3. Am Ende des Abscheideprozesses zur Erzeugung der Verbindungsschicht 31 (d.h. vor einem eventuellen nachfolgenden Planarisieren oder sonstigen teilweisen Abtragen der abgeschiedenen Verbindungsschicht 31), aber auch nach einem eventuellen nachfolgenden Planarisieren oder sonstigen teilweisen Abtragen der abgeschiedenen Verbindungsschicht 31 (d.h. insbesondere auch bei dem fertig prozessierten Leistungshalbleitermodul) kann deren Schichtdicke d31 beispielsweise im Bereich von 20 µm bis 100 µm liegen. Schichtdicken d31 von weniger als 20 µm oder von mehr als 100 µm sind grundsätzlich jedoch ebenso möglich. Da die Verbindungsschicht 31 so ausgelegt werden kann, dass ihre wirksame Länge, die zur Herstellung der elektrischen Verbindung der Metallplatte 3 mit einer Elektrode 11, 21 eines Halbleiterchips 1 oder Substrats 2 oder einer Substratbaugruppe 28 erforderlich ist, sehr kurz ist, und da bei Bedarf zwei oder mehrere Abschnitte der Verbindungsschicht 31 (d.h. zwei oder mehr Kontaktstöpsel 310) elektrisch parallel geschaltet werden können, wenn eine bestimmte Stromtragfähigkeit erreicht werden soll, kann die Schichtdicke d31 der Verbindungsschicht 31 geringer gewählt werden als die maximale Dicke d3 der Metallplatte 3.

Um zu erreichen, dass die Verbindungsschicht 31 eine ebene Oberfläche aufweist, kann die Verbindungsschicht 31 an ihrer dem Halbleiterchip 1 abgewandten Oberfläche noch planarisiert werden, was im Ergebnis in Figur 10 dargestellt ist. Geeignete Planarisierungsverfahren sind beispielsweise Schleifen, Polieren oder Läppen.

Ebenso kann die Metallplatte 3 in den Bereichen, in denen sie von der Verbindungsschicht 31 nach Beendigung des Abscheideprozesses bedeckt war, durch lokales Entfernen der Verbindungsschicht 31 frei gelegt und unterschiedliche Kontaktstöpsel 310 dabei vereinzelt werden, was im Ergebnis in Figur 11 gezeigt ist. Das Freilegen kann wiederum mittels eines Planarisierungsverfahrens wie beispielsweise Schleifen, Polieren oder Läppen erfolgen, bei dem der den Halbleiterchip 1, die Metallplatte 3, die Verbindungsmasse 4 und die elektrisch leitende Verbindungsschicht 31 aufweisende Verbund 7 von der Seite, an der sich die Verbindungsschicht 31 befindet, planarisiert wird.

Die Verbindungsschicht 31 kann aus einem Material, z.B. einem Metall, oder einer Materialmischung, z.B. einer Mischung aus oder mit wenigstens zwei verschiedenen Metallen, bestehen. Geeignete Materialien, die eine solche Verbindungsschicht 31 aufweisen oder aus denen eine solche Verbindungsschicht 31 bestehen kann, sind zum Beispiel Kupfer (Cu), Molybdän (Mo), Aluminium (Al), Nickel (Ni), Zinn (Sn) oder Silber (Ag).

Ebenso ist es jedoch möglich, dass eine Verbindungsschicht 31 zwei oder mehr Teilschichten 31', 31" aus unterschiedlichen Materialien oder unterschiedlichen Materialzusammensetzungen aufweist. Beispielsweise kann eine erste Teilschicht 31' erzeugt werden, wie dies unter Bezugnahme auf Figur 8 für die Verbindungsschicht 31 erläutert wurde. Unmittelbar auf einer solchen ersten Teilschicht 31' kann eine zweite Teilschicht 31" der Verbindungsschicht 31 erzeugt werden, wie dies in Figur 10 dargestellt ist. Das Erzeugen der zweiten Teilschicht 31" kann durch galvanische Abscheidung in einem Galvanikbad erfolgen, wobei die erste Teilschicht 31" als Elektrode für den Galvanikprozess verwendet wird. Wie in Figur 9 dargestellt ist, kann vor dem Galvanikprozess, mit dem die zweite Teilschicht 31" erzeugt wird, auf der ersten Teilschicht 31' im Bereich der Durchgangsöffnung 8 eine dielektrische Maske 81 erzeugt werden, die verhindert, die eine galvanische Abscheidung im Bereich der Maske 81 verhindert, was im Ergebnis in Figur 10 gezeigt ist.

Sofern die Verbindungsschicht 31 eine erste Teilschicht 31' aufweist, sowie zumindest eine weitere Teilschicht 31", kontaktiert die erste Teilschicht 31' sowohl die erste Lastelektrode 11 als auch die Metallplatte 3, sowie, optional, das Substrat 2 (insbesondere eine metallische Oberfläche 2t des Substrats 2) unmittelbar. Demgemäß kann die erste Teilschicht 31' auch die Funktion eines Haftvermittlers übernehmen. Geeignete Materialien, die eine solche erste Teilschicht 31' aufweisen oder aus denen eine solche erste Teilschicht 31' bestehen kann, sind zum Beispiel Titan (Ti); Wolfram (W); Tantal (Ta); Titanwolfram (TiW). Geeignete Materialien für eine unmittelbar auf eine erste Teilschicht 31' aufgebrachte zweite Teilschicht 31" sind zum Beispiel Kupfer (Cu), Molybdän (Mo), Aluminium (Al), Nickel (Ni), Zinn (Sn) oder Silber (Ag).

Sofern eine Verbindungsschicht 31 zwei Teilschichten 31', 31" aufweist, kann sie aus genau einer ersten Teilschicht 31' und einer zweiten Teilschicht 31" bestehen, oder sie kann zwei oder mehr Teilschichten 31', 31" aufweisen.

Am Ende des Abscheideprozesses zur Erzeugung der ersten Teilschicht 31' kann diese eine Schichtdicke d31' (siehe Figur 8) beispielsweise von weniger als 10 µm aufweisen. Schichtdicken d31' von 10 µm oder mehr als sind jedoch ebenfalls möglich. Am Ende des Abscheideprozesses zur Erzeugung der gesamten Verbindungsschicht 31 (d.h. vor einem eventuellen nachfolgenden Planarisieren) kann die Schichtdicke d31 der Verbindungsschicht 31 beispielsweise im Bereich von 20 µm bis 100 µm liegen. Schichtdicken d31 von weniger als 20 µm oder von mehr als 100 µm sind grundsätzlich jedoch ebenso möglich.

Optional kann eine Verbindungsschicht 31 ergänzend auch an der der Metallplatte 3 abgewandten Oberfläche des Verbunds 7 erzeugt werden. Beispielsweise könnte die erste Teilschicht 31' ergänzend auch an der der Metallplatte 3 abgewandten Oberfläche des Verbunds 7 erzeugt und optional die zweite Teilschicht 31" ergänzend auch an der Seite der ergänzenden ersten Teilschicht 31' erzeugt werden, die dem Halbleiterchip 1 abgewandt ist. In den Figuren 8 bis 13 sind die ergänzende erste Teilschicht 31' bzw. die ergänzende zweite Teilschicht 31" gestrichelt dargestellt.

Nach dem galvanischen Abscheiden der zweiten Teilschicht 31" kann die Maske 81 zusammen mit einem im Bereich der Maske 81 befindlichen Abschnitt der ersten Teilschicht 31' entfernt werden, so dass die durch diesen Abschnitt der ersten Teilschicht 31' elektrisch verbundenen Segmente der Metallplatte 3 elektrisch wieder getrennt werden, was beispielsweise mittels eines Ätzprozesses erfolgen kann. Optional kann bei dem Ätzprozess auch ein geringer Teil der zweiten Teilschicht 31" entfernt werden. Figur 11 zeigt die Anordnung nach dem Ätzprozess.

Nach diesem Ätzprozess kann Durchgangsöffnung 8 optional mit einem dielektrischen Masse 4" verfüllt werden, beispielsweise um die Isolationsfestigkeit zwischen den durch die Durchgangsöffnung 8 separierten Segmenten der Metallplatte 3 zu erhöhen, was im Ergebnis in Figur 12 gezeigt ist.

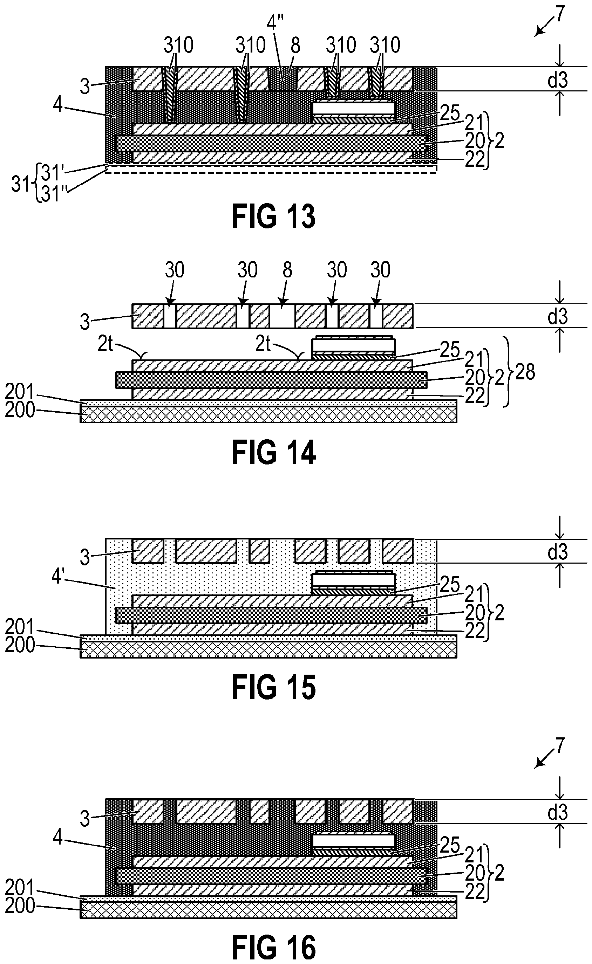

Optional kann die Metallplatte 3 nach dem Erzeugen der zweiten Teilschicht 31" sowie optional auch nach dem Verfüllen der Durchgangsöffnung 8 mit der dielektrischen Masse 4'in den Bereichen, in denen sie am Ende des Abscheideprozesses zur Erzeugung der Verbindungsschicht 31 von der Verbindungsschicht 31 bedeckt war, durch lokales Entfernen der Verbindungsschicht 31 und optional durch lokales Entfernen der dielektrischen Masse 4" frei gelegt und unterschiedliche Kontaktstöpsel 310 dabei vereinzelt werden, was im Ergebnis in Figur 13 dargestellt ist.

Während bei den in den Figuren 1 bis 13 dargestellten Verfahren die Durchgangsöffnungen 30 in einem Zustand in der Metallplatte 3 erzeugt wurden, in dem die Metallplatte 3 bereits durch die Verbindungsmasse 4 stoffschlüssig mit dem Halbleiterchip 1 verbunden war, wird nachfolgend unter Bezugnahme auf die Figuren 14 bis 17 ein Verfahren erläutert, bei dem eine Metallplatte 3 verwendet wird, die eine oder mehr Durchgangsöffnungen 30 bereits zu einem Zeitpunkt aufweist, zu dem die Metallplatte 3 noch nicht durch die Verbindungsmasse 4 stoffschlüssig mit dem Halbleiterchip 1 verbunden ist, wie dies in Figur 14 dargestellt ist. Das Erzeugen dieser einen oder mehr Durchgangsöffnungen 30 kann zum Beispiel mittels eines Ätzverfahrens erfolgen, bei dem eine noch nicht mit dem Halbleiterchip 1 verbundene Metallplatte 3 strukturiert geätzt wird, wie dies bereits unter Bezugnahme auf die Figuren 4 und 5 erläutert wurde. Alternativ können die eine oder mehr Durchgangsöffnungen 30 auch erzeugt werden, indem die noch nicht mit dem Halbleiterchip 1 verbundene Metallplatte 3 mit

Das Substrat 2 kann zumindest eine metallische Oberfläche 2t aufweisen. Das Substrat 2 weist einen dielektrischen Isolationsträger 20 auf, der als flaches Plättchen ausgebildet ist und der eine erste Hauptfläche und eine dieser entgegengesetzte zweite Hauptfläche aufweist. Auf die erste Hauptfläche ist eine erste Substratmetallisierung 21 aufgebracht, die optional zu voneinander beabstandeten Leiterbahnen strukturiert sein kann. Außerdem kann auf die zweite Hauptfläche eine optionale zweite Substratmetallisierung 22 aufgebracht sein. Die zweite Substratmetallisierung 22 ist unstrukturiert, sie kann aber alternativ auch strukturiert sein. Die metallische, elektrisch leitende Oberfläche 2t des Substrats 2 wird durch die dem Isolationsträger 20 abgewandte Oberfläche der ersten Substratmetallisierung 21 gebildet.

Die Substratmetallisierungen 21 und 22 sind mit dem Isolationsträger 20 fest, flächig und stoffschlüssig verbunden. Insbesondere kann die erste Substratmetallisierung 21 über ihre gesamte, dem Isolationsträger 20 zugewandte Seite fest und stoffschlüssig mit dem Isolationsträger 20 verbunden sein. Entsprechend kann auch die zweite Substratmetallisierung 22 (sofern vorhanden) über ihre gesamte, dem Isolationsträger 20 zugewandte Seite fest und stoffschlüssig mit dem Isolationsträger 20 verbunden sein.

Der Isolationsträger 20 ist elektrisch isolierend. Er kann beispielsweise Keramik aufweisen oder aus Keramik bestehen. Geeignete Keramiken sind z.B. Aluminiumoxid (Al₂O₃), Siliziumnitrid (Si₃N₄), Aluminiumnitrid (AlN), oder andere dielektrische Keramiken. Die erste Substratmetallisierung 21 und, sofern vorhanden, die zweite Substratmetallisierung 22 können beispielsweise aus Kupfer, einer Kupferlegierung, Aluminium oder einer Aluminiumlegierung bestehen, oder eines dieser Materialien aufweisen. Andere elektrisch gut leitende Metalle einschließlich Legierungen können jedoch ebenso verwendet werden. Optional können die erste Substratmetallisierung 21 und, sofern vorhanden, die zweite Substratmetallisierung 22, jeweils zwei oder mehr Teilschichten aufweisen, von denen jede aus einem Metall oder einer Metalllegierung besteht.

Gemäß einer Ausgestaltung kann es sich bei dem Substrat 2 um ein DCB-Substrat (DCB = direct copper bonded) handeln, bei dem die erste Substratmetallisierung 21 und, sofern vorhanden, die zweite Substratmetallisierung 22 hergestellt werden, indem jeweils eine vorgefertigte Kupferfolie, die oberflächlich oxidiert ist, durch den DCB-Prozess (DCB kann. Außerdem kann auf die zweite Hauptfläche eine optionale zweite Substratmetallisierung 22 aufgebracht sein. Die zweite Substratmetallisierung 22 ist unstrukturiert, sie kann aber alternativ auch strukturiert sein. Die metallische, elektrisch leitende Oberfläche 2t des Substrats 2 wird durch die dem Isolationsträger 20 abgewandte Oberfläche der ersten Substratmetallisierung 21 gebildet.

Die Substratmetallisierungen 21 und 22 sind mit dem Isolationsträger 20 fest, flächig und stoffschlüssig verbunden. Insbesondere kann die erste Substratmetallisierung 21 über ihre gesamte, dem Isolationsträger 20 zugewandte Seite fest und stoffschlüssig mit dem Isolationsträger 20 verbunden sein. Entsprechend kann auch die zweite Substratmetallisierung 22 (sofern vorhanden) über ihre gesamte, dem Isolationsträger 20 zugewandte Seite fest und stoffschlüssig mit dem Isolationsträger 20 verbunden sein.

Der Isolationsträger 20 ist elektrisch isolierend. Er kann beispielsweise Keramik aufweisen oder aus Keramik bestehen. Geeignete Keramiken sind z.B. Aluminiumoxid (Al₂O₃), Siliziumnitrid (Si₃N₄), Aluminiumnitrid (AlN), oder andere dielektrische Keramiken. Die erste Substratmetallisierung 21 und, sofern vorhanden, die zweite Substratmetallisierung 22 können beispielsweise aus Kupfer, einer Kupferlegierung, Aluminium oder einer Aluminiumlegierung bestehen, oder eines dieser Materialien aufweisen. Andere elektrisch gut leitende Metalle einschließlich Legierungen können jedoch ebenso verwendet werden. Optional können die erste Substratmetallisierung 21 und, sofern vorhanden, die zweite Substratmetallisierung 22, jeweils zwei oder mehr Teilschichten aufweisen, von denen jede aus einem Metall oder einer Metalllegierung besteht.

Gemäß einer Ausgestaltung kann es sich bei dem Substrat 2 um ein DCB-Substrat (DCB = direct copper bonded) handeln, bei dem die erste Substratmetallisierung 21 und, sofern vorhanden, die zweite Substratmetallisierung 22 hergestellt werden, indem jeweils eine vorgefertigte Kupferfolie, die oberflächlich oxidiert ist, durch den DCB-Prozess (DCB = "direct copper bonding") mit einem keramischen Isolationsträger 20, beispielsweise aus Aluminiumoxid, verbunden wird. Alternativ kann es sich bei dem Substrat 2 um ein AMB-Substrat (AMB = active metal bonded) handeln, bei dem eine vorgefertigte Kupferfolie unter Verwendung einer Silizium, Kupfer und Titan enthaltenden Legierung als Hartlot mit einen keramischen Isolationsträger 20, beispielsweise aus Siliziumnitrid, stoffschlüssig verbunden wird. Bei sämtlichen Ausgestaltungen kann, falls gewünscht, zumindest eine der Kupferfolien, nachdem sie mit dem Isolationsträger 20 verbunden wurde, zu Leiterbahnen und/oder Leiterflächen strukturiert werden. Vor oder nach dem Strukturieren kann eine Kupferfolie auf ihrer dem Isolationsträger 20 abgewandten Seite mit einer dünnen metallischen Beschichtung versehen werden, beispielsweise um die Lötbarkeit zu verbessern. Eine solche dünne metallische Beschichtung kann zum Beispiel eines der folgenden Materialien aufweisen oder aus einem der folgenden Materialien bestehen: Nickel (Ni); Gold (Au); Silber (Ag); Platin (Pt).

Allerdings muss der Isolationsträger 20 nicht notwendigerweise aus einer Keramik bestehen. Vielmehr können als Isolationsträger 20 auch nicht-keramische, elektrisch isolierende Materialien wie zum Beispiel Harze verwendet werden, die mit einem Füllstoff hoch gefüllt sind. Als Füllstoff eignen sich beispielsweise körnige dielektrische Füllstoffe mit einer kleinen relativen Dielektrizitätskonstante, beispielsweise wenn hohe Schaltgeschwindigkeiten erzielt werden sollen. In diesem Sinn wird eine relative Dielektrizitätskonstante als gering angesehen, wenn sie, bezogen auf eine Temperatur von 18°C und und eine Frequenz von 50 Hz, kleiner ist als 5. Beispiele für geeignete Füllstoffe sind Siliziumdioxid, Aluminiumoxid, Bornitrid, Siliziumnitrid, Aluminiumnitrid, Diamant oder Glas. Weiterhin wird ein gefülltes Harz dann als "hoch gefüllt" angesehen, wenn die Gesamtmenge des in das Harz eingebetteten Füllstoffs mindestens 60 Volumenprozent vom Gesamtvolumen aus Harz und Füllstoff aufweist. Als Substrate 2 eignen sich aber auch herkömmliche gedruckte Leiterplatten.

Wie nachfolgend anhand der Figuren 18 und 19 erläutert wird, kann als Substrat 2 auch ein metallischer Leiterrahmen ("Leadframe") verwendet werden, der eine metallische, elektrisch leitende Oberfläche 2t aufweist. Ein solcher Leiterrahmen kann im einfachsten Fall aus einem einzigen Metallsegment bestehen. Er kann aber auch zwei oder mehr voneinander getrennte Metallsegmente aufweisen. Ebenfalls ist es möglich, dass der Leiterrahmen zunächst nur ein Metallsegment aufweist, das während des Herstellungsverfahrens des Leistungshalbleitermoduls in zwei oder mehr voneinander getrennte Metallsegmente vereinzelt wird. Der Halbleiterchip 1 kann, wie bereits unter Bezugnahme auf Figur 1 erläutert, mittels einer Verbindungsschicht 25 mit dem Substrat 2 (zum Beispiel mit einer metallischen Oberfläche 2t des Substrats 2) stoffschlüssig sowie elektrisch leitend oder elektrisch isolierend verbunden sein. Abgesehen von dem einzigen Unterschied, dass das Substrat 2 als Leiterrahmen ausgebildet ist, kann ein Leistungshalbleitermodul gemäß einer beliebigen der vorangehend erläuterten Varianten erzeugt werden. Figur 19 zeigt hierzu beispielhaft ein Leistungshalbleitermodul, dessen Aufbau, abgesehen von dem unterschiedlichen Substrat 2, dem in Figur 13 erläuterten Aufbau entspricht. Die Verbindungsschicht 31 kann dabei optional die Metallplatte 3 unmittelbar und elektrisch leitend mit der metallischen Oberfläche 2t des Leiterrahmens 2 verbinden.

Gemäß einem in Figur 20 dargestellten Beispiel kann ein Halbleiterchip 1 auch eine Steuerelektrode 13 aufweisen, mittels der die zwischen der ersten Lastelektrode 11 und der zweiten Lastelektrode 12 ausgebildete Laststrecke angesteuert werden kann, was vorangehend bereits erläutert wurde. Bei dem gezeigten Beispiel sind die erste Lastelektrode 11 und die Steuerelektrode 13 auf dieselbe, dem Substrat 2 abgewandte Oberfläche des Halbleiterkörpers 10 aufgebracht, während die zweite Lastelektrode 12 auf die dem Substrat 2 zugewandte Oberfläche des Halbleiterkörpers 10 aufgebracht ist.

Bei Bedarf kann die Steuerelektrode 13, ebenso wie die erste Lastelektrode 11, mit Hilfe der elektrisch leitenden Verbindungsschicht 31 elektrisch leitend mit der Metallplatte 3 verbunden werden. Um einen elektrischen Kurzschluss zwischen der ersten Lastelektrode 11 und der Steuerelektrode 13 über die Metallplatte 3 zu vermeiden, kann bei dem fertiggestellten Leistungshalbleitermodul die erste Lastelektrode 11 mittels eines ersten Abschnitts der Verbindungsschicht 31 elektrisch leitend mit einem ersten Abschnitt 311 der Metallplatte 3 verbunden sein, und die Steuerelektrode 13 kann mittels eines zweiten Abschnitts der Verbindungsschicht 31 elektrisch leitend mit einem von dem ersten Abschnitt 311 getrennten zweiten Abschnitt 312 der Metallplatte 3 verbunden sein. Dabei bewirken die Metallplatte 3 und die Verbindungsschicht 31 keine elektrisch leitende Verbindung zwischen der ersten Lastelektrode 11 und der Steuerelektrode 13. Der erste Abschnitt 311 und der zweite Abschnitt 312 der Metallplatte 3 können voneinander getrennt werden, nachdem die Metallplatte 3 bereits durch die Verbindungsmasse 4 stoffschlüssig mit dem Halbleiterchip 1 verbunden wurde, was das Handling vereinfacht. Beispielsweise kann das Trennen im Rahmen des unter Bezugnahme auf Figur 4 erläuterten Ätzschrittes erfolgen, wenn die Ätzmaske 5 mit einer weiteren Öffnung 50 derart versehen wird, dass das Ätzmittel 301 während des nachfolgenden Ätzschrittes den ersten Abschnitt 311 und den zweiten Abschnitt 312 trennt. Da das nachfolgende Erzeugen der Verbindungsschicht 31 wieder einen unerwünschten elektrischen Kurzschluss zwischen ersten Abschnitt 311 und den zweiten Abschnitt 312 bewirkt, ist es zweckmäßig, wenn die Verbindungsschicht 31 zumindest in dem Umfang wieder entfernt wird, dass sie den ersten Abschnitt 311 und den zweiten Abschnitt 312 nicht mehr elektrisch verbindet. Dies kann beispielsweise dadurch erfolgen, dass die Metallplatte 3 in den Bereichen, in denen sie von der Verbindungsschicht 31 bedeckt war, durch lokales Entfernen der Verbindungsschicht 31 frei gelegt und unterschiedliche Kontaktstöpsel 310 dabei vereinzelt werden, wie dies im Ergebnis in Figur 20 gezeigt ist und unter Bezugnahme auf Figur 13 erläutert wurde. Das lokale Entfernen der Verbindungsschicht 31 kann optional mittels eines Planarisierungsverfahrens wie beispielsweise Schleifen, Polieren oder Läppen erfolgen, bei dem der den Halbleiterchip 1, die Metallplatte 3, die Verbindungsmasse 4 und die elektrisch leitende Verbindungsschicht 31 aufweisende Verbund 7 an der Seite, an der sich die Verbindungsschicht 31 befindet, planarisiert wird.

Bei allen vorangehend erläuterten Beispielen waren der Halbleiterchip 1 und das Substrat 2 jeweils zu Beginn des Verfahrens bis nach dem Aushärten des das Verbindungsmittel 4 bildenden, fließfähigen Vorprodukts 4'mittels einer Klebeschicht 201 auf einem Hilfsträger 200 angeordnet. Nach dem Herstellen des Verbunds 7, der den Halbleiterchip 1, die Metallplatte 3 und die den Halbleiterchip 1 und die Metallplatte 3 stoffschlüssig verbindende Verbindungsmasse 4 aufweist, können die Klebeschicht 201 und der Hilfsträger 200 zu jedem beliebigen Zeitpunkt von dem Verbund 7 entfernt werden, so dass das Substrat 2 frei liegt. Beispielsweise kann das Entfernen der Klebeschicht 201 und des Hilfsträgers 200 von dem Verbund 7 vor jedem der erläuterten Planarisierungsschritte erfolgen.

Bei den vorangehend erläuterten Beispielen war der Halbleiterchip 1 jeweils mittels einer Verbindungsschicht 25 stoffschlüssig mit einem Substrat 2 verbunden, das einen Bestandteil des fertigen Leistungshalbleitermoduls darstellt. Wie nachfolgend unter Bezugnahme auf die Figuren 21 und 22 erläutert wird, muss ein Halbleiterchip 1 jedoch nicht notwendigerweise auf einem Substrat 2 angeordnet werden. Beispielsweise können bei einem Halbleiterchip 1 die erste Lastelektrode 11 und die zweite Lastelektrode 12 auf entgegengesetzte Oberflächen des Halbleiterkörpers 10 aufgebracht sein. Der Halbleiterchip 1 kann dann an der zweiten Lastelektrode 12 unter Verwendung der Klebeschicht 201 auf den Hilfsträger 200 geklebt werden, so dass der Halbleiterchip 1 an dem Hilfsträger 200 fixiert ist. Das stoffschlüssige Verbinden des Halbleiterchips 1 mit der Metallplatte 3 mittels des Verbindungsmittels 4 sowie alle weiteren unter Bezugnahme auf die vorangehenden Beispiele erläuterten Schritte können, soweit sie nicht das Vorhandensein eines Substrats 2 voraussetzen, können auf dieselbe oder analoge Weise durchgeführt werden. Optional kann der Halbleiterchip 1, wie ebenfalls in Figur 21 dargestellt ist, eine Steuerelektrode 13 aufweisen, die auf dieselbe Oberfläche des Halbleiterkörpers 10 aufgebracht ist wie die zweite Lastelektrode 12. In diesem Fall wird der Halbleiterchip 1 auch an der Steuerelektrode 13 unter Verwendung der Klebeschicht 201 auf den Hilfsträger 200 geklebt.

Nach dem Herstellen des Verbunds 7, der den Halbleiterchip 1, die Metallplatte 3 und die den Halbleiterchip 1 und die Metallplatte 3 stoffschlüssig verbindende Verbindungsmasse 4 aufweist, können die Klebeschicht 201 und der Hilfsträger 200 zu jedem beliebigen Zeitpunkt von dem Verbund 7 entfernt werden, so dass die zweite Lastelektrode 12 und, sofern vorhanden, die Steuerelektrode 13, wie in Figur 22 gezeigt ist, frei liegen und elektrisch kontaktiert werden können. Daher sind die zweite Lastelektrode 12 und, sofern vorhanden, die Steuerelektrode 13 nicht oder zumindest nicht vollständig von der Verbindungsmasse 4 bedeckt.

Gemäß einem weiteren, anhand der Figuren 23 und 24 dargestellten Beispiel kann die vorgefertigte Metallplatte 3, bevor sie durch die Verbindungsmasse 4 stoffschlüssig mit dem Halbleiterchip 1 verbunden wird, unterschiedliche Dicken aufweisen. Eine derartige Ausgestaltung kann beispielsweise genutzt werden, um Materialkosten und Gewicht einzusparen, wenn das fertige Leistungshalbleitermodul aus der vorgefertigten Metallplatte 3 erzeugte Abschnitte 35 aufweist, für die zur Erzielung der erforderlichen Stromtragfähigkeit eine geringere Dicke d35 ausreicht als für andere aus der vorgefertigten Metallplatte 3 erzeugte Abschnitte. Eine Metallplatte 3 mit unterschiedlichen Dicken lässt sich auf einfache Weise z.B. durch Prägen oder Fräsen einer ebenen, eine konstante Dicke aufweisenden Metallplatte herstellen.

Die die unterschiedlich dicke Abschnitte aufweisende Metallplatte 3 kann entsprechend einem beliebigen der vorangehend erläuterten Verfahren mittels einer dielektrischen Verbindungsmasse 4 stoffschlüssig mit dem Halbleiterchip 1 verbunden werden, wobei der Halbleiterchip 1 optional mittels einer Verbindungsschicht 25, ebenfalls wie vorangehend erläutert, stoffschlüssig mit einem beliebigen Substrat 2 verbunden sein kann. Figur 24 zeigt die Anordnung, nachdem der Halbleiterchip 1 durch die Verbindungsmasse 4 stoffschlüssig mit der Metallplatte 3 verbunden wurde. Wie ebenfalls dargestellt ist, kann die Metallplatte 3, bevor sie durch die Verbindungsmasse 4 stoffschlüssig mit dem Halbleiterchip 1 verbunden wird, eine oder mehr Durchgangsöffnungen 30 von einer oder mehr herzustellenden Öffnungen 60 aufweisen. Alternativ oder zusätzlich können ein oder mehr Durchgangsöffnungen 30 auch in der Metallplatte 3 erzeugt werden, nachdem der Halbleiterchip 1 durch die Verbindungsmasse 4 stoffschlüssig mit der Metallplatte 3 verbunden wurde. Die Verwendung einer Metallplatte 3, die unterschiedliche Dicken d3, d35 aufweist, lässt sich bei jedem der vorangehend erläuterten Verfahren realisieren.

Beispielsweise kann ein dünner Abschnitt 35 der Metallplatte 3, der eine Dicke aufweist, die geringer ist als die maximale Dicke d3 der Metallplatte 3, über die Verbindungsschicht 31 mit einem Steueranschluss 13 des Halbleiterchips 1 verbunden sein, um diesem ein elektrisches Ansteuerpotential zuzuführen. Die Verwendung eines dünnen Abschnitts der Metallplatte 3, der eine Dicke aufweist, die geringer ist als die maximale Dicke d3 der Metallplatte 3, kann generell sinnvoll sein, wenn die geringere Dicke ausreicht, damit der Abschnitt mit der geringeren Dicke die erforderliche Stromtragfähigkeit aufweist.

Nachfolgend wird unter Bezugnahme auf die Figuren 25 bis 28 beispielhaft erläutert, dass eine durch eine Verbindungsschicht 31 erzeugte elektrisch leitende Verbindung zwischen der ersten Lastelektrode 11 und der Metallplatte 3 nicht notwendigerweise unter Verwendung einer in der Metallplatte 3 ausgebildeten Durchgangsöffnung 30 hergestellt werden muss. Wie in Figur 25 und im Ergebnis in Figur 26 dargestellt ist, kann ein Laserstrahl 302 seitlich neben der Metallplatte 3 in der Verbindungsmasse 4 eine Öffnung 60 erzeugen, die keine in der Metallplatte 3 ausgebildete Durchgangsöffnung 30 aufweist, und die sich bis zu der ersten Lastelektrode 31 erstreckt, so dass die erste Lastelektrode 11 in dem Abschnitt 40 (und damit in der Öffnung 60) frei liegt. Der Abschnitt 40 bildet dann die Öffnung 60. Nachfolgend kann dann gemäß einem der vorangehend erläuterten Beispiele eine Verbindungsschicht 31 auf dem den Halbleiterchip 1, die Metallplatte 3 sowie die den Halbleiterchip 1 und die Metallplatte 3 stoffschlüssig verbindenden Verbund 7 erzeugt werden, was anhand der Figuren 27 und 28, lediglich beispielhaft, für eine Verbindungsschicht 31 dargestellt ist, die eine erste Teilschicht 31' und eine unmittelbar auf die erste Teilschicht 31' aufgebrachte zweite Teilschicht 31" aufweist. Sämtliche anderen vorangehend erläuterten Varianten zur Erzeugung einer Verbindungsschicht 31 einschließlich eventueller Planarisierungsschritte und Schritte zum teilweisen Entfernen der Verbindungsschicht 31 von der Metallplatte 3 können jedoch ebenso und nach Belieben eingesetzt werden. Ein gemäß dem vorliegenden Beispiel erzeugter Kontaktstöpsel 310 lässt sich in Kombination mit einem beliebigen anderen Kontaktstöpsel 310 herstellen, der sich, wie bei den vorangehenden Beispielen erläutert, durch eine in der Metallplatte 3 ausgebildeten Durchgangsöffnung 30 hindurch erstreckt.

Anhand der Figuren 29 und 30 wird noch gezeigt, dass eine Metallplatte 3 eine oder mehr Verankerungsstrukturen 33 aufweisen kann, an denen sich die Verbindungsmasse 4 verkrallen kann, was zu einer verbesserten Verbindung zwischen der der Metallplatte 3 und der Verbindungsmasse 4 führt. Bei dem Beispiel gemäß Figur 29 kann eine Verankerungsstruktur 33 als Vorsprung der Metallplatte 3 ausgebildet sein, während Figur 30 zeigt, dass eine Verankerungsstruktur 33 auch als Vertiefung der Metallplatte 3 ausgebildet sein kann. Eine Verankerungsstruktur 33 kann optional auch eine Hinterschneidung aufweisen. Die Geometrie einer als Vorsprung oder Vertiefung ausgebildeten Verankerungsstruktur 33 der Metallplatte 3 sowie die Position einer Verankerungsstruktur 33 an der Metallplatte 3 können beliebig gewählt werden, solange die Verankerungsstruktur 33 in physischem Kontakt mit der Verbindungsmasse 4 steht. Eine weitere, zu einer Verankerungsstruktur 33 alternative oder ergänzende Möglichkeit, die Festigkeit der Verbindung zwischen der Metallplatte 3 und der Verbindungsmasse 4 zu erhöhen, besteht darin, diejenige Oberfläche der Metallplatte 3, die bei dem fertigen Leistungshalbleitermodul dem Halbleiterchip 1 zugewandt ist (also die Oberfläche, die die größte Kontaktfläche mit der Verbindungsmasse 4 besitzt, aufzurauen, bevor das fließfähige Vorprodukt 4' der dielektrischen Verbindungsmasse 4 zwischen den Halbleiterchip 1 und die Metallplatte 3 eingebracht wird.

Bei den vorangehend erläuterten Beispielen wurde gezeigt, wie eine elektrisch leitende Verbindungsschicht 31 anhand eines ein- oder mehrstufigen Abscheideverfahrens erzeugt werden kann. Nachfolgend werden unter Bezugnahme auf die Figuren 31 bis 38 weitere Beispiel erläutert, wie eine elektrisch leitende Verbindungsschicht unter Verwendung einer verfestigbaren elektrisch leitenden Masse 34' erfolgen kann, die in eine oder mehr der Öffnungen 60 eingebracht und nachfolgend verfestigt wird. Die verfestigte, ebenfalls elektrisch leitende Masse ist jeweils mit dem Bezugszeichen 34 gekennzeichnet. Die elektrisch leitende Masse bildet ganz oder teilweise die Verbindungsschicht 31. Je nach Art der verfestigbaren elektrisch leitenden Masse 34' kann das Verfestigen durch zumindest eines von Abkühlen, Aushärten und Sintern erfolgen.

Das Einbringen der verfestigbaren Masse 34' kann optional so erfolgen, dass die verfestigbare elektrisch leitende Masse 34' zumindest die in einer der Öffnungen 60 frei liegende erste Lastelektrode 11 sowie die Metallplatte 3 jeweils sowohl elektrisch als auch physisch kontaktiert. Ebenso ist es jedoch möglich, eine oder mehr Teilschichten 31', 31" zu erzeugen, wie dies unter Bezugnahme auf die vorangehenden Figuren erläutert wurde, und nachfolgend die verfestigbare elektrisch leitende Masse 34' auf die eine oder die mehr Teilschichten 31', 31" aufzubringen, so dass die verfestigbare elektrisch leitende Masse 34' eine (31") der Teilschichten unmittelbar kontaktiert.

Um zu vermeiden, dass überquellende oder überschüssige Abschnitte der verfestigten Masse 34 zu Kurzschlüssen führen, können diese Abschnitte entfernt werden, war prinzipiell durch ein beliebiges Verfahren erfolgen kann. Lediglich beispielhaft seinen Polieren, Läppen, Ätzen, Spülen genannt.

Bei dem Beispiel gemäß Figur 31 wird die verfestigbare elektrisch leitende Masse 34' in die eine oder die mehr Öffnungen 60 gepresst, was beispielhaft mittels eines Rakels 500 erfolgt. Ebenso wäre es jedoch möglich, die verfestigbare elektrisch leitende Masse 34' mit einem beliebigen anderen geeigneten Verfahren in die Öffnungen 60 einzubringen. Beispielsweise könnte die verfestigbare elektrisch leitende Masse 34' mittels einer Düse jeweils lokal in die einzelnen Öffnungen 60 eingespritzt werden. Nach dem Einbringen der verfestigbaren elektrisch leitenden Masse 34' in die wenigstens eine Öffnung 60 wird die Masse 34' verfestigt, was im Ergebnis in Figur 32 gezeigt ist.

Bei der verfestigbaren elektrisch leitenden Masse 34' kann es sich beispielsweise um eine Lotpaste handeln, oder um eine Paste, die ein Metallpulver und ein Lösemittel enthält (z.B. eine Sinterpaste, die ein Metallpulver und ein Lösemittel enthält, oder eine Klebstoffverbindung, die ein Metallpulver enthält). Im Fall eines Lots wird das in die wenigstens eine Öffnung 60 eingebrachte Lot aufgeschmolzen und nachfolgend bis unter seine Solidustemperatur abgekühlt, so dass es sich verfestigt. Im Fall einer Paste, die ein Metallpulver und ein Lösemittel enthält, wird die in die wenigstens eine Öffnung 60 eingebrachte Paste durch teilweises oder vollständiges Verdampfen des Lösemittels verfestigt. Im Fall einer Sinterpaste folgt auf das teilweise oder vollständige Verdampfen des Lösemittels noch ein Temperaturschritt, bei dem das in der wenigstens einen Öffnung 60 zurückgebliebene Metallpulver gesintert wird. Das Verfestigen des zurückgebliebenen Metallpulvers erfolgt dadurch, dass die Teilchen des Metallpulvers beim Sintern relativ zueinander fixiert werden. Das Sintern kann optional drucklos erfolgen, d.h. ohne dass während des Temperaturschritts ein externer Druck auf das in der wenigstens einen Öffnung 60 zurückgebliebene Metallpulver ausgeübt wird. Alternativ zu einem drucklosen Sintern kann das Sintern auch erfolgen, indem das in der Öffnung 60 zurückgebliebene Metallpulver während des Temperaturschritts mit einem Druck beaufschlagt und dadurch komprimiert wird. Dies kann beispielsweise dadurch erfolgen, dass die Anordnung in eine deformierbare Umhüllung (z.B. eine Folie oder eine Gelumhüllung) eingebracht und dann (z.B. über eine Flüssigkeit) isostatisch mit einem Druck beaufschlagt wird (z.B. durch isostatisches Heißpressen), der größer ist als der Umgebungsdruck (z.B. wenigstens 1 MPa bar absolut), so dass der isostatische Druck das zurückgebliebene Metallpulver mittelbar über die Umhüllung komprimiert. Für die Durchführung des Temperaturschritts zum drucklosen Sintern oder zum Sintern mit Druck kann der Verbund 7 in einen Ofen eingebracht werden, der die zum Sintern erforderliche Temperatur erzeugt. Alternativ kann das in der wenigstens einen Öffnung 60 zurückgebliebene Metallpulver auch durch Lasersintern gesintert werden.

Gemäß einem anhand der Figuren 33 bis 35 erläuterten Verfahren kann eine schmelzbare (und damit feste) elektrisch leitende Ausgangsmasse 34" oberhalb der wenigstens einen Öffnung 60 platziert und danach zu einer verfestigbaren elektrisch leitenden Masse 34' aufgeschmolzen werden, so dass sie in die Öffnungen 60 fließt. Danach kann die in die Öffnungen 60 befindliche verfestigbare elektrisch leitende Masse 34' durch Abkühlen bis unter ihre Solidustemperatur zu der festen Masse 34 verfestigt werden, was im Ergebnis in Figur 34 gezeigt ist. Überschüssige Abschnitte der verfestigten Masse 34 können, wie bereits erläutert und im Ergebnis in Figur 35 gezeigt, entfernt werden, um unerwünschte Kurzschlüssen zu vermeiden.

Während sich bei dem Beispiel gemäß Figur 33 die schmelzbare elektrisch leitende Ausgangsmasse 34" zusammenhängend (z.B. in Form eines Plättchens wie beispielsweise eines Lotplättchens) über zwei oder mehr der Öffnungen 60 hinweg erstreckt, besteht auch die Möglichkeit, einzelne, nicht zusammenhängende Ausgangsmasseteilchen 34" über und/oder in einer oder mehr der Öffnungen 60 zu platzieren, was in Figur 36 schematisch dargestellt ist. Bei einem solchen Ausgangsmasseteilchen 34" kann es sich, wie in Figur 36 gezeigt, um z.B. um eine Kugel handeln, aber auch um einen anderen Körper. Ebenso könnte zum Beispiel auch in eine oder mehr der Öffnungen 60 ein stabförmiges Ausgangsmasseteilchen 34" eingesteckt werden. Eine weitere alternative Möglichkeit besteht darin, in eine oder mehr der Öffnungen 60 jeweils mehrere Ausgangsmasseteilchen 34" in Form eines Pulvers einzufüllen. Nach dem Platzieren der Ausgangsmasseteilchen 34" in der jeweils erläuterten Position werden diese zu einer verfestigbaren Masse 34' aufgeschmolzen. Danach kann die in die Öffnungen 60 befindliche verfestigbare elektrisch leitende Masse 34' durch Abkühlen bis unter ihre Solidustemperatur zu der festen Masse 34 verfestigt werden, was im Ergebnis in Figur 37. Bei dem Beispiel gemäß den Figuren 36 und 37 war die Ausgangsmasse 34" so bemessen, dass die Öffnungen 60 durch die feste Masse 34 vollständig verfüllt wurden. Davon abweichend könnte die Ausgangsmasse 34" aber auch so bemessen werden, dass die Öffnungen 60 durch die feste Masse 34 nicht vollständig verfüllt werden. Auch bei den anhand der Figuren 36 und 37 erläuterten Beispielen können überschüssige Abschnitte der verfestigten Masse 34 können optional entfernt werden.

Bei den anhand der Figuren 31 bis 37 erläuterten Verfahren bestand durch verfestigten Masse 34 jeweils ein direkter physischer und elektrischer Kontakt zwischen der Metallplatte 3 und der in einer der Öffnungen 60 frei liegenden Lastelektrode 11, sowie optional auch zwischen der in einer der Öffnungen 60 frei liegenden, metallischen Oberfläche des Substrats 2. Allerdings kann die verfestigte Masse 34 auch so erzeugt werden, dass sie zumindest in den Öffnungen 60 jeweils unmittelbar auf einer oder mehr abgeschiedenen Teilschichten 31' aufliegt, wie sie vorangehend erläutert wurden. Als Beispiel hierfür zeigt Figur 37 ein zu dem Beispiel gemäß Figur 33 analoges Beispiel. Hier weist der Verbund 7 vor dem Platzieren der schmelzbaren Ausgangsmasse 34" zumindest eine Teilschicht 31' auf. Die Herstellung der verfestigen Masse 34 kann so erfolgen, wie dies unter Bezugnahme auf die Figuren 31 bis 37 erläutert wurde, mit dem Unterschied, dass vor dem Platzieren der verfestigbaren Masse 34' und, soweit zutreffend, vor dem Platzieren der elektrisch leitenden Ausgangsmasse 34", eine oder mehr abgeschiedenen Teilschichten 31' erzeugt wurden, wie dies vorangehend unter Bezugnahme auf die Figuren 1 bis 30 erläutert wurde, mit der Maßgabe, dass die eine oder die mehr abgeschiedenen Teilschichten 31' die Öffnungen 60 nicht vollständig verfüllen. Sofern auf einer oder mehr Teilschichten 31' eine verfestigte, elektrisch leitende Masse 34 erzeugt wird, sind die eine bzw. mehr Teilschichten 31' und die elektrisch leitende Masse 34 Bestandteile der Verbindungsschicht 31.

Anhand der vorangehend erläuterten Beispiele wurden verschiedenste Varianten erläutert, wie eine Verbindungsschicht 31 dazu verwendet werden kann, zumindest eine elektrisch leitende Verbindung zwischen einer Metallplatte 3 und einer ersten Lastelektrode 11 eines Halbleiterchips 1 herzustellen, und wie dieselbe Verbindungsschicht 31 optional auch dazu verwendet werden kann, zumindest eine weitere elektrisch leitende Verbindung zwischen derselben Metallplatte 3 und einem weiteren elektrischen Element (z.B. einer ersten Substratmetallisierung 21 oder einem als Leadframe ausgebildeten Substrat 2) herzustellen. Ebenfalls erläutert wurde, wie die Metallplatte 3 optional in zwei oder mehr voneinander getrennte Segmente aufgeteilt werden kann, so dass ein derartiges Segment jeweils eine Leiterbahn bildet, die auf beliebige Weise zur elektrischen Verschaltung des Leistungshalbleitermoduls eingesetzt werden kann.

Indem die Verbindungsschicht 31 zumindest dazu eingesetzt wird, die erste Lastelektrode 11 des Halbleiterchips 1 elektrisch leitend mit der Metallplatte 3 oder einem Segment der Metallplatte 3 zu verbinden, kann ein Segment der Metallplatte 3 in Zusammenwirkung mit einem oder mehr Kontaktstöpseln 310 einen Bonddraht ersetzen, wie er bei herkömmlichen Leistungshalbleitermodulen verwendet wird, so dass die eingangs beschriebenen, bei der Verwendung von Bonddrähten auftretenden Probleme vermieden werden. Als Beispiel hierfür wurde vorangehend anhand der Figuren 11, 12, 13, 19, 20, 21 und 24 gezeigt, dass bei dem fertigen Leistungshalbleitermodul ein Segment der ursprünglichen Metallplatte 3 mittels einer Verbindungsschicht 31 mit einer ersten Lastelektrode 11 eines Halbleiterchips 1 oder mit einem Substrat 2 elektrisch verbunden sein kann, so dass die erste Lastelektrode 11 und das Substrat 2 dauerhaft elektrisch leitend miteinander verbunden sind. Ebenso ist es jedoch möglich, dass ein Segment der Metallplatte 3 mittels wenigstens eines Kontaktstöpsels 310 mit der ersten Lastelektrode 11 und mittels wenigstens eines weiteren Kontaktstöpsels 310 mit dem Substrat 2 elektrisch verbunden ist.

Das vorangehend erläuterte Verfahren mit all seinen Ausgestaltungen und Weiterbildungen ermöglicht es, Bonddrähte zu ersetzen, die bei einem herkömmlichen Leistungshalbleitermodul eingesetzt werden. Als "Bonddrähte" werden dabei Drähte verstanden, die durch Drahtbonden unmittelbar an eine Metallisierung (zum Beispiel eine Elektrode 11, 12, 13 eines Halbleiterchips 1 oder eine Metallisierung 21, 22 eines Substrats 2) gebondet werden, indem ein kurzer Abschnitt des Bonddrahts mittels eines Bondwerkzeugs unmittelbar an die Metallisierung gepresst wird, so dass der Bonddraht in dem betreffenden Abschnitt eine stoffschlüssige und feste Verbindung mit der Metallisierung eingeht, und zwar ohne dass ein zusätzliches Verbindungsmittel wie beispielsweise ein Lot oder ein Kleber eingesetzt wird. Eine solche Verbindung wird auch als Drahtbondverbindung bezeichnet. Als Bonddrähte werden dabei sowohl Drähte mit kreisförmigem Querschnitt als auch solche mit nicht-kreisförmigem Querschnitt verstanden. Optional kann ein fertiggestelltes Leistungshalbleitermodul, das nach einem Verfahren gemäß der vorliegenden Erfindung hergestellt wurde, generell keine Drahtbondverbindung aufweisen, oder zumindest bis zu dem Zeitpunkt keine Drahtbondverbindung aufweisen, zu dem die Metallplatte 3 mittels der Verbindungsmasse 4 stoffschlüssig mit dem Halbleiterchip 1 verbunden wird. Allerdings ist es auch möglich, dass ein nach einem Verfahren gemäß der vorliegenden Erfindung hergestelltes Leistungshalbleitermodul eine oder mehr Drahtbondverbindungen aufweist oder durch eine oder mehr Drahtbondverbindungen mit modulexternen Bauteilen, Geräten oder Anordnungen elektrisch verbunden wird.

Da die bei herkömmlichen Leistungshalbleitermodulen eingesetzten Bonddrähte üblicherweise sequentiell an die erforderlichen Metallisierungen gebondet werden, ist damit ein hoher Zeitaufwand verbunden. Im Vergleich dazu ermöglicht die vorliegende Erfindung eine deutliche Zeitersparnis, da die Kontaktstöpsel 310 simultan hergestellt werden können.

Durch die Verwendung der Metallplatte 3, die problemlos so ausgelegt werden kann, dass sie im Vergleich zu Bonddrähten, wie sie bei einem herkömmlichen Leistungshalbleitermodul mit denselben elektrischen Funktionen und derselben Leistungsklasse eingesetzt werden, eine wesentlich höhere Wärmekapazität besitzt, so dass das Leistungshalbleitermodul eine höhere Temperaturwechselfestigkeit aufweist als ein herkömmliches Leistungshalbleitermodul. Die wesentlich höhere Wärmekapazität bewirkt, dass Temperaturschwankungen, wie sie im für Leistungshalbleitermodule typischen Schaltwechselbetrieb in einem Halbleiterchip 1 auftreten, weniger stark ausfallen, so dass der Unterschied zwischen der maximalen Chiptemperatur und der minimalen Chiptemperatur geringer ist, als bei einem herkömmlichen Leistungshalbleitermodul (gleiche elektrische Belastung vorausgesetzt). Außerdem ergibt sich durch die Metallplatte 3 eine Wärmespreizung und damit einhergehend eine bessere Kühlung als bei herkömmlichen Leistungshalbleitermodulen.

Des Weiteren besteht die Möglichkeit, elektrische Anschlüsse direkt an die Metallplatte 3 oder an ein Segment der Metallplatte 3 zu schweißen.

Wie nachfolgend anhand der Figuren 39 bis 43 erläutert wird, können zwei oder mehr Leistungshalbleitermodule unter Verwendung einer gemeinsamen Metallplatte simultan gefertigt und nachfolgend vereinzelt werden. Das gezeigte Beispiel basiert auf dem Beispiel gemäß den Figuren 1 bis 9.

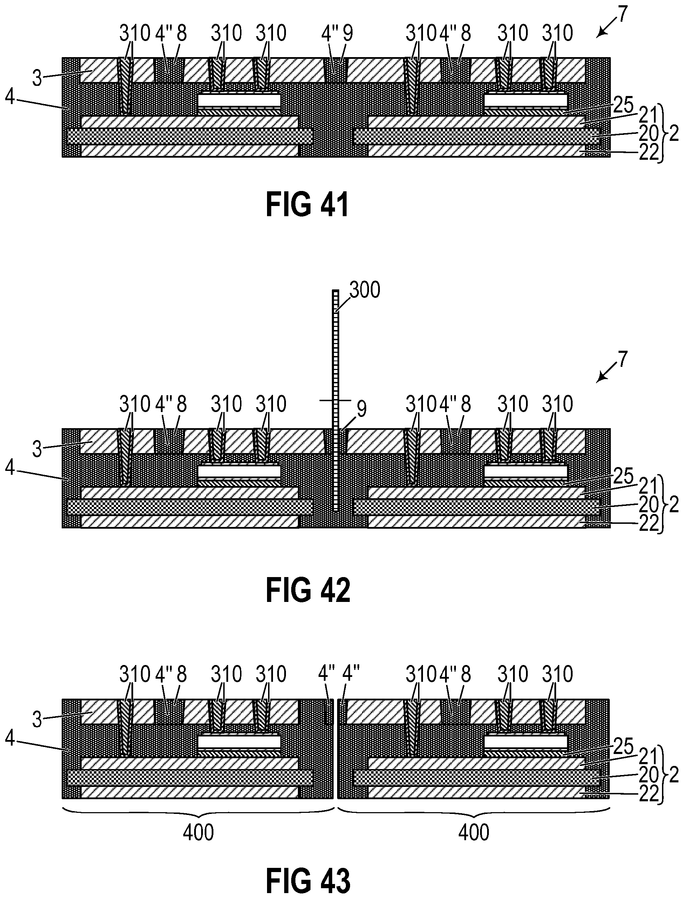

Bei dem Beispiel gemäß der mit Figur 4 korrespondierenden Figur 39 wurde auf zwei oder mehr vorgefertigten separaten Substraten 2 jeweils wenigstens ein Halbleiterchip 1 angeordnet und mittels einer Verbindungsschicht 25 stoffschlüssig mit dem vorgefertigten Substrat 2 verbunden. Jeder dieser Halbleiterchips 1 wurde durch dieselbe dielektrische Verbindungsmasse 4 stoffschlüssig mit einer einzigen Metallplatte 3 verbunden, und es wurde auf der Oberfläche der Metallplatte 3 eine strukturierte Ätzmaskenschicht 5 derart erzeugt, dass sich eine der Maskenöffnungen 50 (in Figur 39 ist dies die mittlere der Maskenöffnungen) oberhalb eines Zwischenraums zwischen benachbarten Substraten 2 befindet. Durch Einwirkung des Ätzmittels 301 auf die Metallplatte 3 im Bereich dieser Maskenöffnung wird in der Metallplatte 3 eine Durchgangsöffnung 9 erzeugt, der die Metallplatte 3 in zwei oder mehr Segmente trennt, was im Ergebnis in Figur 40 gezeigt ist, die im Übrigen mit Figur 6 korrespondiert. Die Durchgangsöffnung 9 kann optional simultan mit einem oder mehreren Durchgangsöffnungen 8 mit einer dielektrischen Masse 4" gefüllt werden, wie dies unter Bezugnahme auf die Figuren 8 bis 13 für die Durchgangsöffnung 8 erläutert wurde, was im Ergebnis in Figur 41 dargestellt ist. Die Durchgangsöffnung 9 ist so positioniert, dass der Verbund 7 durch Sägen anhand eines ebenen Schnitts in zwei (oder mehr) Leistungshalbleitermodule 400 vereinzelt werden kann, der durch keine metallischen Teile verläuft, was in Figur 42 dargestellt ist. Das Sägen kann beispielsweise mittels eines Sägeblatts 300 erfolgen. Figur 43 zeigt die beiden vereinzelten Leistungshalbleitermodule 400.

Wie weiter anhand der Figuren 44 bis 48 erläutert wird, können zwei oder mehr voneinander getrennte Substrate 2 oder zwei oder mehr voneinander getrennte Substratbaugruppen 28 basierend auf einem Verfahren, wie es vorangehend erläutert wurde, durch die Metallplatte 3 elektrisch miteinander verbunden werden. Bei dem Beispiel gemäß der mit Figur 1 korrespondierenden Figur 44 wurde auf zwei oder mehr vorgefertigten separaten Substraten 2 jeweils wenigstens ein Halbleiterchip 1 angeordnet und mittels einer Verbindungsschicht 25 stoffschlüssig mit dem vorgefertigten Substrat 2 verbunden, so dass zwei oder mehr voneinander getrennte Substratbaugruppen 28 vorliegen. Um die Substratbaugruppen 28 in einer vorgegebenen relativen Lage zueinander zu fixieren, können sie, beispielsweise mittels einer Klebeschicht 201, vorübergehend auf einem Hilfsträger 200 befestigt werden.

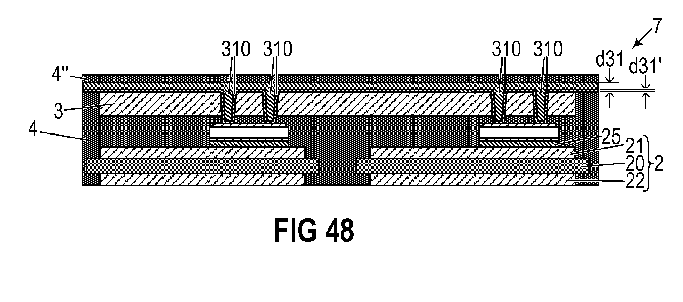

Zwischen die Substratbaugruppen 28 und die Metallplatte 3 und damit zwischen die Substrate 2, die Halbleiterchips 1 und die Metallplatte 3 wird, wie vorangehend unter Bezugnahme auf die Figuren 2 und 3 erläutert, ein fließfähiges Vorprodukt 4' der dielektrischen Verbindungsmasse 4 eingebracht (Figur 45) und nachfolgend zu einem die Verbindungsmasse 4 bildenden festen Körper ausgehärtet, der sich durchgehend zwischen jeder der Substratbaugruppen 28 und der Metallplatte 3 erstreckt und der die Substratbaugruppen 28 und die Metallplatte 3 stoffschlüssig miteinander zu einem Verbund verbindet. Dabei erstreckt sich der feste Körper auch durchgehend zwischen den Substraten 2 sowie zwischen den Halbleiterchips 1 und verbindet diese stoffschlüssig miteinander. Figur 46 zeigt die Anordnung nach dem Aushärten des Vorprodukts 4', dem nachfolgenden optionalen Entfernen des Hilfsträgers 200 und der Klebeschicht 201, sowie nach dem auf das Aushärten folgenden Erzeugen einer strukturierten Ätzmaskenschicht 5 auf der Metallplatte 3, während des Ätzens der Metallplatte 3 mit einem Ätzmittel 301 unter Verwendung der strukturierten Ätzmaskenschicht 5, wie vorangehend unter Bezugnahme auf Figur 4 erläutert. Wie anhand von Figur 47, die den Verbund 7 nach dem Ätzvorgang zeigt, zu erkennen ist, weist die Metallplatte 3 mehrere Durchgangsöffnungen 30 von herzustellenden Öffnungen 60 (analog zu den Erläuterungen betreffend Figur 7) auf. Die weiteren Schritte können so durchgeführt werden, wie dies unter Bezugnahme auf die Figuren 8 bis 13 erläutert wurde. Figur 48 zeigt einen Verbund 7, der analog zu dem Verbund 7 gemäß Figur 12 hergestellt wurde. Wie sich aus Figur 48 in Verbindung den Figuren 44 bis 47 ergibt, können durch die Metallplatte 3 und eine Verbindungsschicht 31 beliebig viele Substratbaugruppen 28, die ursprünglich elektrisch (galvanisch) getrennt waren, elektrisch leitend miteinander verbunden werden, indem für jede der elektrisch zu verbindenden Substratbaugruppen 28 eine Elektrode dieser Substratbaugruppe 28 mittels der Metallplatte 3 und der Verbindungsschicht 31 mit jeweils einer Elektrode zumindest einer der anderen elektrisch zu verbindenden Substratbaugruppen 28 elektrisch leitend verbunden wird. Als Elektrode einer Substratbaugruppe 28 kommt beispielsweise eine erste Lastelektrode 11 eines Halbleiterchips 1 der Substratbaugruppe 28 in Frage, oder eine Steuerelektrode 13 eines Halbleiterchips 1 der Substratbaugruppe 28, oder eine Substratmetallisierung 21 eines Substrats 2 der Substratbaugruppe 28. Bei dem Beispiel gemäß Figur 48 weisen die Substratbaugruppen 28 jeweils einen Halbleiterchip 1 mit einer ersten Lastelektrode 11 auf, und die Metallplatte 3 und die Verbindungsschicht 31 verbinden diese ersten Lastelektroden 11 elektrisch leitend miteinander. Alternativ oder zusätzlich besteht die Möglichkeit, eine Substratmetallisierung 21 eines Substrats 2 einer ersten Substratbaugruppe 28 und eine Substratmetallisierung 21 eines Substrats 2 einer zweiten Substratbaugruppe 28 mittels der Metallplatte 3 und der Verbindungsschicht 31 elektrisch leitend miteinander zu verbinden. Alternativ oder zusätzlich zu den beiden bereits genannten Alternativen besteht auch die Möglichkeit, eine Substratmetallisierung 21 eines Substrats 2 einer ersten Substratbaugruppe 28 mit einer ersten Lastelektrode 11 oder einer Steuerelektrode 13 eines Halbleiterchips 1 einer zweiten Substratbaugruppe 28 mittels der Metallplatte 3 und der Verbindungsschicht 31 elektrisch leitend miteinander zu verbinden.

Mit der vorangehenden Beschreibung wurden verschiedene Beispiele erläutert, wie ein elektrisches Bauteil (z.B. ein Halbleiterchip 1 oder ein Substrat 2) zunächst unter Verwendung einer Verbindungsmasse 4 stoffschlüssig mit einer vorgefertigten Metallplatte 3 verbunden und danach eine elektrisch leitende Oberfläche eines Bauteils (z.B. eine Oberfläche einer Lastelektrode 11 eines Halbleiterchips 1 oder eine Oberfläche 2t eines Substrats 2) mittels einer elektrisch leitenden Verbindung 31, 310 elektrisch leitend mit der Metallplatte 3 verbunden werden kann. Eine elektrisch leitende Verbindung kann dabei mittels einer Verbindungsschicht 31, die einschichtig ausgebildet ist oder die zwei oder mehr Teilschichten 31', 31" aufweist, und/oder mittels einer verfestigten Masse 34 erzeugt werden. Sofern nicht anders erwähnt können die anhand der verschieden Beispiele erläuterten Varianten auf beliebige Weise kombiniert werden. Soweit in einem Beispiel für ein Element mit einem bestimmten Bezugszeichen Angaben zum Material, der Materialzusammensetzung, dem Aufbau oder den Abmessungen dieses Elements gemacht wurden, können diese Angaben auch auf Elemente mit demselben Bezugszeichen übertragen werden, die in anderen Beispielen eingesetzt werden. Insbesondere kann die Metallplatte 3 bei allen Varianten der Erfindung optional vollständig oder zu wenigstens 50 Gewichtsprozent aus Kupfer bestehen. Bei allen Varianten der Erfindung, bei denen eine elektrisch leitende Verbindung 31, 310 eine Verbindungsschicht 31 aufweist, kann frei gewählt werden, ob eine Verbindungsschicht 31 nur aus einer ersten Schicht 31' besteht, oder aus einer ersten Teilschicht 31' und einer oder mehr weiteren Teilschichten 31". Die Dicke d31 bezeichnet stets die Schichtdicke der gesamten Verbindungsschicht 31. Weiterhin kann bei allen Varianten der Erfindung für jede einzelne Öffnung 60 frei gewählt werden, ob sie durch die Verbindung 31, 310 vollständig oder nur teilweise gefüllt wird. Ebenfalls kann bei allen Varianten der Erfindung frei gewählt werden, ob die maximale Dicke d3 der Metallplatte 3 größer, kleiner oder gleich der Schichtdicke d31 der Verbindungsschicht 31 gewählt wird. Außerdem kann bei allen Varianten der Erfindung frei gewählt werden, ob in der Metallplatte 3 eine oder mehr Durchgangsöffnungen 8 erzeugt werden, die die Metallplatte 3 in zwei oder mehr Segmente trennen, und/oder ob in der Metallplatte 3 eine oder mehr Durchgangsöffnungen 9 erzeugt werden, die die Metallplatte 3 in zwei oder mehr Segmente trennen und in deren Bereich der Verbund 7 jeweils anhand eines ebenen Schnitts, der nicht durch Metall verläuft, zu einzelnen Leistungshalbleitermodulen 400 vereinzelt wird.

Wie ebenfalls anhand der vorangehenden Beispiele erläutert wurde, weist eine Öffnung 60 zumindest einen Abschnitt 40 auf, der sich in der Verbindungsmasse 4 befindet und in dem eine Elektrode (beispielsweise eine Lastelektrode 11 eines Halbleiterchips 1, eine Leiterbahn 21 eines Substrats 2, oder ein beliebiges anderes mit der Metallplatte 3 elektrisch zu verbindendes Element) frei liegt. Dabei kann eine Öffnung 60 - unabhängig von eventuellen anderen Öffnungen 60 - nur aus ihrem Abschnitt 40 bestehen (siehe hierzu beispielsweise Figur 26), oder sie kann ihren Abschnitt 40 sowie eine Durchgangsöffnung 30 aufweisen (siehe hierzu beispielsweise die Figuren 5 bis 7). Demgemäß weist eine Öffnung 60 zumindest einen (ersten) Abschnitt 40 auf, und sie kann optional noch einen in der Metallplatte 3 ausgebildeten zweiten Abschnitt, nämlich eine Durchgangsöffnung 30, umfassen.

## Patentansprüche

1. Verfahren, das aufweist:
Erzeugen einer ersten Öffnung (60), die sich in eine dielektrische Verbindungsmasse (4) hinein erstreckt, welche einen ersten Halbleiterchip (1) und eine Metallplatte (3) stoffschlüssig miteinander verbindet, so dass in der ersten Öffnung (60) eine erste Lastelektrode (11) des ersten Halbleiterchips (1) frei liegt; und
Erzeugen einer ersten elektrisch leitenden Verbindung (31, 310), die die in der ersten Öffnung (60) frei liegende erste Lastelektrode (11) des ersten Halbleiterchips (1) kontaktiert und diese elektrisch leitend mit der Metallplatte (3) verbindet,
**dadurch gekennzeichnet, dass**, bevor die Metallplatte (3) durch die Verbindungsmasse (4) stoffschlüssig mit dem ersten Halbleiterchip (1) verbunden wird, eine erste Substrateinheit (28) erzeugt wird, bei der der erste Halbleiterchip (1) stoffschlüssig mit einem ersten Substrat (2) verbunden ist,
das erste Substrat (2) einen dielektrischen Isolationsträger (20) aufweist, der als flaches Plättchen ausgebildet ist und der eine erste Hauptfläche und eine dieser entgegengesetzte zweite Hauptfläche aufweist; und
auf die erste Hauptfläche eine erste Substratmetallisierung (21) aufgebracht ist.

2. Verfahren gemäß Anspruch 1, bei dem der erste Halbleiterchip (1) und die Metallplatte (3) stoffschlüssig miteinander verbunden werden, indem ein fließfähiges Vorprodukt (4') der dielektrischen Verbindungsmasse (4) zwischen den ersten Halbleiterchip (1) und die Metallplatte (3) eingebracht und nachfolgend zu einem die Verbindungsmasse (4) bildenden festen Körper, der sich durchgehend zwischen dem ersten Halbleiterchip (1) und der Metallplatte (3) erstreckt, ausgehärtet wird.

3. Verfahren gemäß Anspruch 1 oder 2, bei dem:
ein erster Abschnitt (30) der ersten Öffnung (60) in der Metallplatte (3) erzeugt wird, bevor die Metallplatte (3) durch die Verbindungsmasse (4) stoffschlüssig mit dem ersten Halbleiterchip (1) verbunden wird; und
ein zweiter Abschnitt (40) der ersten Öffnung (60) in der Verbindungsmasse (4) erzeugt wird, nachdem die Metallplatte (3) durch die Verbindungsmasse (4) stoffschlüssig mit dem ersten Halbleiterchip (1) verbunden wurde.

4. Verfahren gemäß Anspruch 1 oder 2, bei dem:
ein erster Abschnitt (30) der ersten Öffnung (60) in der Metallplatte (3) erzeugt wird, nachdem sie durch die Verbindungsmasse (4) stoffschlüssig mit dem ersten Halbleiterchip (1) verbunden wurde; und
in der Verbindungsmasse (4) nach dem Erzeugen des ersten Abschnitts (30) der ersten Öffnung (60) ein zweiter Abschnitt (40) der ersten Öffnung (60) erzeugt wird.

5. Verfahren gemäß Anspruch 3 oder 4, bei dem der erste Abschnitt (30) der ersten Öffnung (60) durch maskiertes Ätzen der Metallplatte (3) erzeugt wird.

6. Verfahren gemäß einem der Ansprüche 3 bis 5, bei dem der zweite Abschnitt (40) der ersten Öffnung (60) dadurch erzeugt wird, dass die Verbindungsmasse (4) mittels eines Laserstrahls (302) geöffnet wird.

7. Verfahren gemäß einem der vorangehenden Ansprüche, bei dem das Erzeugen der ersten elektrisch leitenden Verbindung (31, 310) umfasst:
Erzeugen einer elektrisch leitenden ersten Teilschicht (31') der elektrisch leitenden Verbindung (31); und nachfolgend
Erzeugen einer elektrisch leitenden zweiten Teilschicht (31") der elektrisch leitenden Verbindung (31) unmittelbar auf der ersten Teilschicht (31'), wobei die erste Teilschicht (31') aus einem anderen Material besteht als die zweite Teilschicht (31").

8. Verfahren gemäß einem der vorangehenden Ansprüche, bei dem das Erzeugen der ersten elektrischen Verbindung (31, 310) das Erzeugen einer Schicht (31, 31', 31"), die eine Schichtdicke (d31) aufweist, die kleiner ist, als eine maximale Dicke (d3) der Metallplatte (3), durch zumindest ein Abscheideverfahren aufweist.

9. Verfahren gemäß einem der Ansprüche 1 bis 6, bei dem das Erzeugen der ersten elektrisch leitenden Verbindung (31, 310) umfasst:
Elektrisch leitendes Verbinden der in der ersten Öffnung (60) frei liegenden ersten Lastelektrode (11) des ersten Halbleiterchips (1) mit der Metallplatte (3) mittels einer elektrisch leitenden, verfestigbaren Masse (34'); und nachfolgend
Verfestigen der verfestigbaren, elektrisch leitenden Masse (34').

10. Verfahren gemäß einem der vorangehenden Ansprüche,
das, bevor die Metallplatte (3) durch die Verbindungsmasse (4) stoffschlüssig mit dem ersten Halbleiterchip (1) verbunden wird, das Erzeugen einer von der ersten Substrateinheit (28) getrennten zweiten Substrateinheit (28) aufweist, bei der ein zweiter Halbleiterchip (1) stoffschlüssig mit einem zweiten Substrat (2) verbunden ist,
bei dem die dielektrische Verbindungsmasse (4) den ersten Halbleiterchip (1), den zweiten Halbleiterchip (1) und die Metallplatte (3) stoffschlüssig miteinander verbindet;
bei dem eine zweite Öffnung (60) erzeugt wird, die sich in die dielektrische Verbindungsmasse (4) hinein erstreckt, so dass in der zweiten Öffnung (60) eine erste Lastelektrode (11) des zweiten Halbleiterchips (1) frei liegt; und
bei dem eine zweite elektrisch leitende Verbindung (31, 310) erzeugt wird, die die in der zweiten Öffnung (60) frei liegende erste Lastelektrode (11) des zweiten Halbleiterchips (1) kontaktiert und elektrisch leitend mit der Metallplatte (3) verbindet.

11. Leistungshalbleitermodul, das aufweist:
eine dielektrische Verbindungsmasse (4), die einen Halbleiterchip (1) und eine Metallplatte (3) stoffschlüssig miteinander verbindet und in die sich eine Öffnung (60) hinein erstreckt, durch die sich eine elektrisch leitende Verbindung (31, 310) erstreckt, die die erste Lastelektrode (11) kontaktiert und elektrisch leitend mit der Metallplatte (3) verbindet, **dadurch gekennzeichnet, dass**
der erste Halbleiterchip (1) Bestandteil einer ersten Substrateinheit (28) ist, die ein erstes Substrat (2) und den mit dem ersten Substrat (2) stoffschlüssig verbundenen ersten Halbleiterchip (1) aufweist;
das erste Substrat (2) einen dielektrischen Isolationsträger (20) aufweist, der als flaches Plättchen ausgebildet ist und der eine erste Hauptfläche und eine dieser entgegengesetzte zweite Hauptfläche aufweist; und
auf die erste Hauptfläche eine erste Substratmetallisierung (21) aufgebracht ist.

12. Leistungshalbleitermodul gemäß Anspruch 11 mit einem Substrat (2), das durch die dielektrische Verbindungsmasse (4) stoffschlüssig mit der Metallplatte (3) verbunden ist und auf dem der mindestens eine Halbleiterchip (1) angeordnet ist.

13. Leistungshalbleitermodul gemäß Anspruch 11 oder 12, bei dem zumindest eine Chipelektrode (12, 13) des Halbleiterchips (1) frei zugänglich ist.

14. Leistungshalbleitermodul gemäß einem der Ansprüche 11 bis 13, das aufweist:
wenigstens zwei paarweise voneinander getrennte Substratbaugruppen (28), von denen jede ein mit einem Halbleiterchip (1) bestücktes Substrat (2) aufweist;
eine Metallplatte (3);
eine dielektrische Verbindungsmasse (4), die die Substratbaugruppen (28) und die Metallplatte (3) stoffschlüssig miteinander verbindet; und
eine elektrisch leitende Verbindungsschicht (31, 310), wobei
sich in die Verbindungsmasse (4) für jede der Substratbaugruppen (28) jeweils eine Öffnung (60) hinein erstreckt, durch die ein Abschnitt der elektrisch leitenden Verbindungsschicht (31, 310) verläuft, der eine Elektrode (11, 21) der betreffenden Substratbaugruppe (28) kontaktiert und elektrisch leitend mit der Metallplatte (3) verbindet.

## Claims

1. Method, which comprises:
producing a first opening (60) which extends into a dielectric bonding compound (4) which connects a first semiconductor chip (1) and a metal plate (3) to one another in a materially bonded manner such that a first load electrode (11) of the first semiconductor chip (1) is exposed in the first opening (60); and
producing a first electrically conductive connection (31, 310) which makes contact with the first load electrode (11) of the first semiconductor chip (1) exposed in first opening (60) and electrically conductively connects same to the metal plate (3),
**characterized in that**, before the metal plate (3) is connected to the first semiconductor chip (1) in a materially bonded manner by way of the bonding compound (4), a first substrate unit (28) is produced, in which the first semiconductor chip (1) is connected to a first substrate (2) in a materially bonded manner,
the first substrate (2) comprises a dielectric isolation carrier (20) which is designed as a small flat plate and comprises a first main face and a second main face opposite the first main face; and
a first substrate metallization (21) is applied to the first main face.

2. Method according to Claim 1, in which the first semiconductor chip (1) and the metal plate (3) are connected to one another in a materially bonded manner by virtue of a fluid precursor (4') of the dielectric bonding compound (4) being introduced between the first semiconductor chip (1) and the metal plate (3) and subsequently being cured to form a solid body, which forms the bonding compound (4) and extends continuously between the first semiconductor chip (1) and the metal plate (3).

3. Method according to Claim 1 or 2, in which:
a first section (30) of the first opening (60) is produced in the metal plate (3) before the metal plate (3) is connected to the first semiconductor chip (1) in a materially bonded manner by way of the bonding compound (4); and
a second section (40) of the first opening (60) is produced in the bonding compound (4) after the metal plate (3) has been connected to the first semiconductor chip (1) in a materially bonded manner by way of the bonding compound (4).

4. Method according to Claim 1 or 2, in which:
a first section (30) of the first opening (60) is produced in the metal plate (3) after it has been connected to the first semiconductor chip (1) in a materially bonded manner by way of the bonding compound (4); and
a second section (40) of the first opening (60) is produced in the bonding compound (4) after the production of the first section (30) of the first opening (60).

5. Method according to Claim 3 or 4, in which the first section (30) of the first opening (60) is produced by masked etching of the metal plate (3).

6. Method according to one of Claims 3 to 5, in which the second section (40) of the first opening (60) is produced by opening the bonding compound (4) by means of a laser beam (302).

7. Method according to one of the preceding claims, in which the production of the first electrically conductive connection (31, 310) comprises:
producing an electrically conductive first sublayer (31') of the electrically conductive connection (31); and subsequently
producing an electrically conductive second sublayer (31") of the electrically conductive connection (31) directly on the first sublayer (31'), wherein the first sublayer (31') consists of a different material to the second sublayer (31").

8. Method according to one of the preceding claims, in which the production of the first electrical connection (31, 310) comprises the production of a layer (31, 31', 31") having a layer thickness (d31) that is smaller than a maximum thickness (d3) of the metal plate (3) by way of at least one deposition method.

9. Method according to one of Claims 1 to 6, in which the production of the first electrically conductive connection (31, 310) comprises:
electrically conductively connecting the first load electrode (11), exposed in the first opening (60), of the first semiconductor chip (1) to the metal plate (3) by means of an electrically conductive, solidifiable compound (34'); and subsequently
solidifying the solidifiable, electrically conductive compound (34').

10. Method according to one of the preceding claims,
which, before the metal plate (3) is connected to the first semiconductor chip (1) in a materially bonded manner by way of the bonding compound (4), comprises the production of a second substrate unit (28), separate from the first substrate unit (28), in which second substrate unit a second semiconductor chip (1) is connected to a second substrate (2) in a materially bonded manner,
in which the dielectric bonding compound (4) connects the first semiconductor chip (1), the second semiconductor chip (1) and the metal plate (3) to one another in a materially bonded manner;
in which a second opening (60) is produced, which extends into the dielectric bonding compound (4) so that a first load electrode (11) of the second semiconductor chip (1) is exposed in the second opening (60); and
in which a second electrically conductive connection (31, 310) is produced, which makes contact with the first load electrode (11) of the second semiconductor chip (1) exposed in the second opening (60) and electrically conductively connects same to the metal plate (3).

11. Power semiconductor module, which comprises:
a dielectric bonding compound (4) which connects a semiconductor chip (1) and a metal plate (3) to one another in a materially bonded manner and into which extends an opening (60) through which an electrically conductive connection (31, 310) extends, which makes contact with the first load electrode (11) and electrically conductively connects same to the metal plate (3), **characterized in that**
the first semiconductor chip (1) is a constituent part of a first substrate unit (28) which comprises a first substrate (2) and the first semiconductor chip (1) connected to the first substrate (2) in a materially bonded manner;
the first substrate (2) comprises a dielectric isolation carrier (20) which is designed as a small flat plate and comprises a first main face and a second main face opposite the first main face; and
a first substrate metallization (21) is applied to the first main face.

12. Power semiconductor module according to Claim 11 comprising a substrate (2) which is connected to the metal plate (3) in a materially bonded manner by way of the dielectric bonding compound (4) and is arranged on the at least one semiconductor chip (1).

13. Power semiconductor module according to Claim 11 or 12, in which at least one chip electrode (12, 13) of the semiconductor chip (1) is freely accessible.

14. Power semiconductor module according to one of Claims 11 to 13, which comprises:
at least two substrate assemblies (28) separated from one another in pairs, each of which comprises a substrate (2) populated with a semiconductor chip (1);
a metal plate (3);
a dielectric bonding compound (4) which connects the substrate assemblies (28) and the metal plate (3) to one another in a materially bonded manner; and
an electrically conductive connection layer (31, 310), wherein
a respective opening (60) extends into the bonding compound (4) for each of the substrate assemblies (28), through which respective opening a section of the electrically conductive connecting layer (31, 310) runs, the electrically conductive connecting layer making contact with an electrode (11, 21) of the relevant substrate assembly (28) and electrically conductively connecting same to the metal plate (3).

## Revendications

1. Procédé, qui a :
la production d'une première ouverture (60), qui s'étend à l'intérieur d'une masse (4) diélectrique de liaison, qui relie entre elles, à coopération de matière, une première puce (1) à semiconducteur et une plaque (3) métallique, de manière à ce qu'une première électrode (11) de charge de la première puce (1) à semiconducteur repose librement dans la première ouverture (60) ; et
la production d'une première liaison (31, 310) conductrice de l'électricité, qui est en contact avec la première électrode (11) de charge de la première puce (1) à semiconducteur reposant librement dans la première ouverture (60) et relie celle-ci d'une manière conductrice de l'électricité à la plaque (3) métallique,
**caractérisé en ce que**, avant de relier la plaque (3) métallique par la masse (4) de liaison à coopération de matière à la première puce (1) à semiconducteur, on produit une première unité (28) de substrat, dans laquelle la première puce (1) à semiconducteur est reliée à coopération de matière à un premier substrat (2),
le premier substrat (2) a un support (20) diélectrique isolant, qui est constitué sous la forme d'une plaquette plane et qui a une première surface principale et une deuxième surface principale opposée à celle-ci ; et
une première métallisation (21) de substrat est déposée sur la première surface principale.

2. Procédé suivant la revendication 1, dans lequel on relie ensemble à coopération de matière la première puce (1) à semiconducteur et la plaque (3) métallique, en introduisant un précurseur (4') apte à s'écouler, de la masse (4) diélectrique de liaison entre la première puce (1) à semiconducteur et la plaque (3) métallique et en le durcissant ensuite en un corps solide, qui forme la masse (4) de liaison et qui s'étend d'une manière continue entre la première puce (1) à semiconducteur et la plaque (3) métallique.

3. Procédé suivant la revendication 1 ou 2, dans lequel :
on produit un premier tronçon (30) de la première ouverture (60) dans la plaque (3) métallique, avant de relier, à coopération de matière, par la masse (4) de liaison, la plaque (3) métallique à la première puce (1) à semiconducteur ; et
on produit un deuxième tronçon (40) de la première ouverture (60) dans la masse (4) de liaison, après que la plaque (3) métallique a été reliée à coopération de matière, par la masse (4) de liaison, à la première puce (1) à semiconducteur.

4. Procédé suivant la revendication 1 ou 2, dans lequel :
on produit un premier tronçon (30) de la première ouverture (60) dans la plaque (3) métallique, après qu'elle a été reliée, à coopération de matière, par la masse (4) de liaison, à la première puce (1) à semiconducteur ; et
on produit dans la masse (4) de liaison, après la production du premier tronçon (30) de la première ouverture (60), un deuxième tronçon (40) de la première ouverture (60) .

5. Procédé suivant la revendication 3 ou 4, dans lequel on produit le premier tronçon (30) de la première ouverture (60) par attaque masquée de la plaque (3) métallique.

6. Procédé suivant l'une des revendications 3 à 5, dans lequel on produit le deuxième tronçon (40) de la première ouverture (60) en ouvrant la masse (4) de liaison au moyen d'un faisceau (302) laser.

7. Procédé suivant l'une des revendications précédentes, dans lequel la production de la première liaison (31, 310) conductrice de l'électricité comprend :
la production d'une première couche (31') partielle conductrice de l'électricité de la liaison (31) conductrice de l'électricité ; et ensuite
la production d'une deuxième couche (31") partielle conductrice de l'électricité de la liaison (31) conductrice d'électricité, directement sur la première couche (31') partielle, la première couche (31') partielle étant en un matériau autre que la deuxième couche (31") partielle.

8. Procédé suivant l'une des revendications précédentes, dans lequel la production de la première liaison (31, 310) électrique comporte la production d'une couche (31, 31', 31"), qui a une épaisseur (d31) de couche plus petite qu'une épaisseur (d3) maximum de la plaque (3) métallique, par au moins un procédé de dépôt.

9. Procédé suivant l'une des revendications 1 à 6, dans lequel la production de la première liaison (31, 310) de conductrice de l'électricité comprend :
la liaison conductrice de l'électricité de la première électrode (11) de charge de la première puce (1) à semiconducteur, reposant librement dans la première ouverture (60), à la plaque (3) métallique au moyen d'une masse (34') pouvant être solidifiée et conductrice de l'électricité ;et ensuite
la solidification de la masse (34') électrique pouvant être solidifiée.

10. Procédé suivant l'une des revendications précédentes,
dans lequel, avant de relier la plaque (3) métallique à la première puce (1) à semiconducteur à coopération de matière, par la masse (4) de liaison, on produit une deuxième unité (28) de substrat, distincte de la première unité (28) de substrat, dans laquelle une deuxième puce (1) à semiconducteur est reliée, à coopération de matière, au deuxième substrat (2),
dans lequel la masse (4) diélectrique de liaison relie entre elles à coopération de matière, la première puce (1) à semiconducteur, la deuxième puce (1) à semiconducteur, et la plaque (3),
dans lequel, on produit une deuxième ouverture (60), qui s'étend à l'intérieur de la masse (4) diélectrique de liaison, de manière à ce qu'une première électrode (11) de charge de la deuxième puce (1) à semiconducteur repose librement dans la deuxième ouverture (60) ; et
dans lequel on produit une deuxième liaison (31, 310) conductrice de l'électricité, qui est en contact avec la première électrode (11) de charge de la deuxième puce (1) à semiconducteur reposant librement dans la deuxième ouverture (60) et la relie, d'une manière conductrice de l'électricité, à la plaque (3) métallique.

11. Module à semiconducteur de puissance, qui comporte :
une masse (4) diélectrique de liaison, qui relie entre elles, à coopération de matière, une puce (1) à semiconducteur et une plaque (3) et dans laquelle s'étend une ouverture (60), dans laquelle s'étend une liaison (31, 310) conductrice de l'électricité, qui est en contact avec la première électrode (11) de charge et la relie d'une manière conductrice de l'électricité à la plaque (3) métallique, **caractérisé en ce que**
la première puce (1) à semiconducteur est une partie constitutive d'une première unité (28) de substrat, qui a un premier substrat (2) et la première puce (1) à semiconducteur reliée, à coopération de matière, au le premier substrat (2) ;
le premier substrat (2) a un support (20) diélectrique isolant, qui est constitué sous la forme d'une plaquette plane et qui a une première surface principale et une deuxième surface principale opposée à celle-ci ; et
sur la première surface principale est déposée une première métallisation (21) de substrat.

12. Module à semiconducteur de puissance suivant la revendication 11, comprenant un substrat (2), qui est relié, à coopération de matière, à la plaque (3) métallique par la masse (4) diélectrique de liaison et sur lequel est disposée la au moins une puce (1) à semiconducteur.

13. Module à semiconducteur de puissance suivant la revendication 11 ou 12, dans lequel au moins une électrode (12, 13) de la puce (1) à semiconducteur est accessible librement.

14. Module à semiconducteur de puissance suivant l'une des revendications 11 à 13, qui comporte :
au moins deux groupes (28) de substrat séparés les uns des autres paire par paire, dont chacun a un substrat (2) équipé d'une puce (1) à semiconducteur ;
une plaque (3) métallique ;
une masse (4) diélectrique de liaison, qui relie entre eux, à coopération de matière, les groupes (28) de substrat et la plaque (3) métallique ;
une couche (31, 310) de liaison conductrice de l'électricité, dans lequel
dans la masse (4) de liaison s'étend pour chacun des groupes (28) de substrat respectivement une première ouverture (60), dans laquelle s'étend une partie de la couche (31, 310) de liaison conductrice de l'électricité, qui est en contact avec une électrode (11, 21) du groupe (28) de substrat concerné et qui la relie d'une manière conductrice de l'électricité à la plaque (3) métallique.
